(19) Europäisches Patentamt

European Patent Office

Office européen des brevets

(11) EP 1 659 698 A1

(12) **EUROPEAN PATENT APPLICATION**
published in accordance with Art. 158(3) EPC

(43) Date of publication:
24.05.2006 Bulletin 2006/21

(51) Int Cl.:
*H04B 1/04* (1968.09)

(21) Application number: 04792868.4

(22) Date of filing: 22.10.2004

(86) International application number:
PCT/JP2004/015726

(87) International publication number:
WO 2005/041427 (06.05.2005 Gazette 2005/18)

(84) Designated Contracting States:
DE FR GB

(30) Priority: 24.10.2003 JP 2003365273
24.10.2003 JP 2003365274
24.10.2003 JP 2003365275

(71) Applicant: MATSUSHITA ELECTRIC INDUSTRIAL
CO., LTD.
Kadoma-shi, Osaka 571-8501 (JP)

(72) Inventor: MIURA, Ritsu
Kanagawa 239-0847 (JP)

(74) Representative: Grünecker, Kinkeldey,
Stockmair & Schwanhäusser
Anwaltssozietät
Maximilianstrasse 58
80538 München (DE)

(54) **ELECTRIC POWER MEASURING APPARATUS, ELECTRIC POWER CONTROL APPARATUS, WIRELESS COMMUNICATION APPARATUS, AND ELECTRIC POWER MEASURING METHOD**

(57) A power measuring apparatus capable of accurate power measurement through segment averaging of a signal obtained by code division multiplexing a plurality of channels having different periods or timings at which their power levels change, a power control apparatus and radio communication apparatus provided with this power measuring apparatus and a power measuring method are disclosed. In this power measuring apparatus, an averaging start timing control section (105) inputs an averaging start timing signal to an averaging section (103) based on information input from a power change timing analysis section (106) when a longest segment identified by the power change timing analysis section (106) arrives. When the averaging start timing signal is input, the averaging section (103) starts to calculate a segment mean value of the input signal.

FIG.4

**Description**

Technical Field

The present invention relates to a radio communication apparatus making up a base station or mobile station, etc., used in a radio communication system, a power control apparatus or power measuring apparatus provided for this radio communication apparatus and a power measuring method realized by this radio communication apparatus.

Background Art

Conventionally, a radio communication apparatus used in a radio communication system incorporates a power control apparatus to keep the power level of a transmission signal within a predetermined range. Furthermore, this power control apparatus incorporates a power measuring apparatus to measure the power level of a transmission signal 1 (e.g., see Patent Document 1).

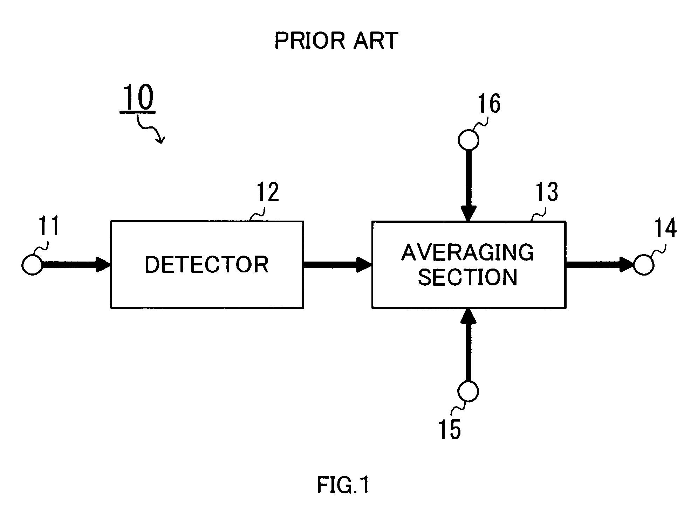

FIG. 1 is a block diagram showing the configuration of a conventional common power measuring apparatus 10. The power measuring apparatus 10 includes a signal input terminal 11, a detector 12, an averaging section 13, a measurement result output terminal 14, an averaging start timing signal input terminal 15 and an averaging time setting input terminal 16.

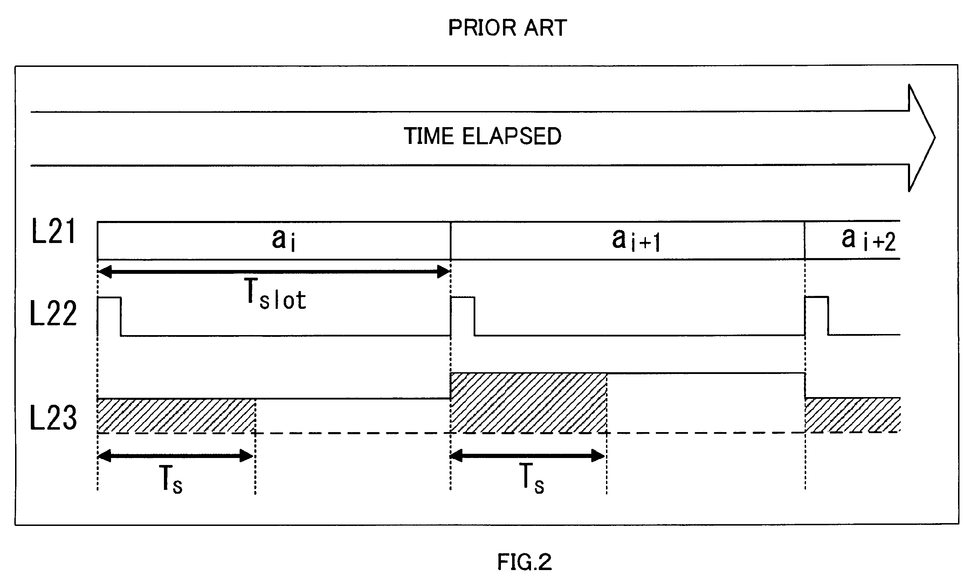

FIG.2 shows the power level, etc., of signal power of each slot of channel A input to the signal input terminal 11 when the power measuring apparatus 10 is applied to a radio communication system whose power level varies from one slot to another. In FIG.2, line L21 shows a slot configuration of channel A, line L22 shows a slot synchronization signal indicating that a boundary between slots arrives and line L23 shows the power level of each slot. Furthermore, line L21 shows slot numbers $a_i$, $a_{i+1}$ and $a_{i+2}$ and a slot length $T_{slot}$ of channel A and line L23 shows a power averaging time $T_S$ to calculate a mean value of the power level and an amount of power (shaded area in the figure) during the power averaging time $T_S$.

Next, the operation of the power measuring apparatus 10 will be explained with reference to FIG.1 and FIG.2 as appropriate. A signal input to the signal input terminal 11 is converted by the detector 12 to a signal of a voltage, etc., indicating the power level. Next, the power level signal converted to a voltage, etc., is averaged by the averaging section 13 in synchronization with a slot synchronization signal shown by line L22 input from the averaging start timing signal input terminal 15, converted to a power mean value with respect to the power averaging time $T_S$ input from the averaging time setting input terminal 16 and output from the measurement result output terminal 14.

[Patent Document 1] Japanese Patent PublicationNo. 6-91398

Disclosure of Invention

Problems to be Solved by the Invention

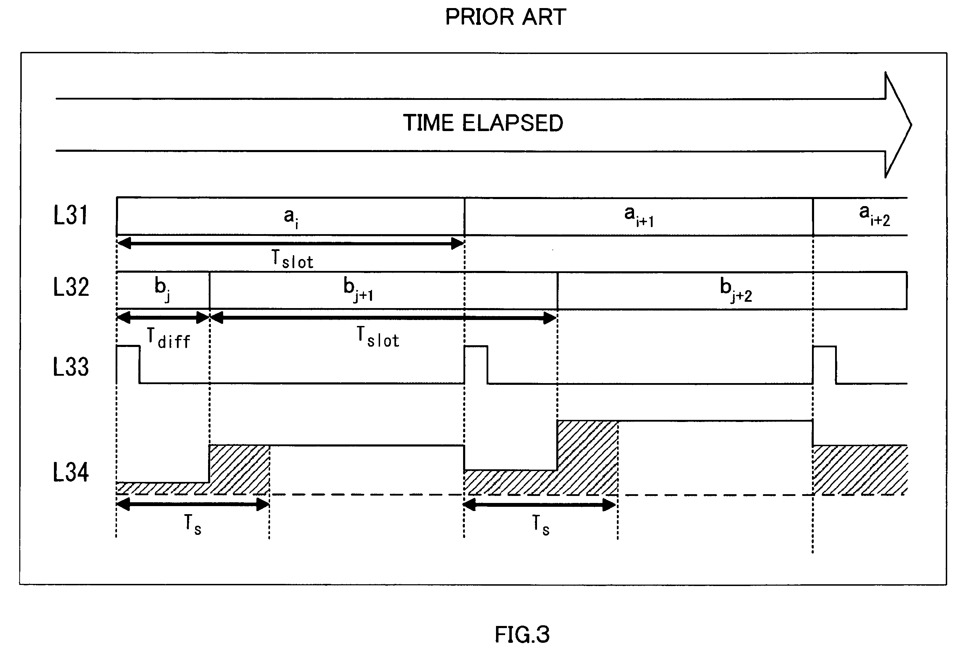

However, the conventional power measuring apparatus 10 may have difficulty in accurately measuring the power level of a signal obtained by code division multiplexing a plurality of channels whose power level varies at different periods or timings. FIG.3 shows the power level, etc., of a signal obtained by code division multiplexing a plurality of channels having different timings at which their power levels change. In FIG.3, line L31 shows the slot configuration of channel A, line L32 shows the slot configuration of channel B, line L33 shows a slot synchronization signal of channel A, line L34 shows the power level of a signal obtained by code division multiplexing channel A and channel B, that is, a total signal power level. Furthermore, line L31 shows slot numbers $a_i$, $a_{i+1}$, $a_{i+2}$ of channel A, line L32 shows slot numbers $b_j$, $b_{j+1}$, $b_{j+2}$ of channel B and line L34 shows a power averaging time $T_S$. Furthermore, in FIG. 3, $T_{slot}$ denotes the slot length of channel A and channel B and $T_{diff}$ denotes the time difference between slots of channel A and channel B.

Since the total signal power level changes between the beginning and the end of the time difference $T_{diff}$ between the slot boundaries of channel A and channel B, when the time difference $T_{diff}$ between the slot boundaries overlaps with the power averaging time $T_S$, the total signal power level also naturally changes, and therefore it is difficult to measure the total signal power level accurately.

It is an object of the present invention to provide a power measuring apparatus capable of accurately measuring, through segment averaging, also the power level of a signal obtained by code division multiplexing a plurality of channels whose power level changes at different periods or at timings, a power control apparatus and radio communication apparatus provided with this power measuring apparatus, and a power measuring method.

Means for Solving the Problem

The power measuring apparatus according to the present invention comprises a detector that generates a power level signal showing a power level of an input signal, an averaging section that calculates a mean value of the power level signal and a control section that causes the averaging section to start to calculate a mean value based on a timing at which the power level of the input signal changes.

The radio communication apparatus according to the present invention comprises a power control apparatus provided with the power measuring apparatus.

The power measuring method according to the present invention comprises a detection step of generating a power level signal indicating a power level of an input signal, an averaging step of calculating a mean value of the power level signal and a control step of causing the averaging step to start to calculate a mean value based on the timing at which the power level of the input signal changes.

Advantageous Effect of the Invention

In accordance with the present invention, averaging of the power level of an input signal is started in synchronization with the start timing of a segment in which the power level of the input signal does not change, and therefore it is possible to measure the power level accurately. As a result, the present invention allows the power level of an amplified transmission/reception signal to be kept within an appropriate range, making it possible to improve the communication quality.

Brief Description of Drawings

FIG.1 is a block diagram showing the configuration of a conventional power measuring apparatus;
FIG.2 is a timing chart illustrating the operation of the conventional power measuring apparatus;
FIG.3 is a timing chart illustrating the operation of the conventional power measuring apparatus;
FIG.4 is a block diagram showing the configuration of a power measuring apparatus according to Embodiment 1 of the present invention;
FIG.5 is a timing chart illustrating the operation of the power measuring apparatus according to Embodiment 1 of the present invention;
FIG.6 is a timing chart illustrating the operation of the power measuring apparatus according to Embodiment 1 of the present invention;
FIG.7 is a timing chart illustrating the operation of the power measuring apparatus according to Embodiment 1 of the present invention;
FIG.8 is a block diagram showing the configuration of a power measuring apparatus according to Embodiment 2 of the present invention;
FIG.9 is a block diagram showing the configuration of a power measuring apparatus according to Embodiment 3 of the present invention;
FIG.10 is a block diagram showing the configuration of a power measuring apparatus according to Embodiment 4 of the present invention;
FIG.11 is a block diagram showing the configuration of a power control apparatus according to Embodiment 5 of the present invention;
FIG.12 is a block diagram showing the configuration of a power control apparatus according to Embodiment 6 of the present invention;
FIG.13 is a block diagram showing the configuration of a power control apparatus according to Embodiment 7 of the present invention;
FIG.14 is a block diagram showing the configuration of a power control apparatus according to Embodiment 8 of the present invention;
FIG.15 is a block diagram showing the configuration of a power measuring apparatus according to Reference Example 1;
FIG.16 is a timing chart illustrating the operation of the power measuring apparatus according to Reference Example 1;
FIG.17 is a timing chart illustrating the operation of the power measuring apparatus according to Reference Example 1;
FIG.18 is a block diagram showing the configuration of a power measuring apparatus according to Reference Example 2;

FIG.19 is a block diagram showing the configuration of a power measuring apparatus according to Reference Example 3;

FIG.20 is a block diagram showing the configuration of a power control apparatus according to Reference Example 4;

FIG.21 is a block diagram showing the configuration of a power control apparatus according to Reference Example 5;

FIG.22 is a block diagram showing the configuration of a power control apparatus according to Reference Example 6;

FIG.23 is a block diagram showing the configuration of a power control apparatus according to Reference Example 7;

FIG.24 is a block diagram showing the configuration of a power control apparatus according to Reference Example 8;

FIG.25 is a timing chart illustrating the operation of the power control apparatus according to Reference Example 8; and

FIG.26 is a block diagram showing the configuration of a power control apparatus according to Reference Example 9.

Best Mode for Carrying Out the Invention

(Embodiment 1)

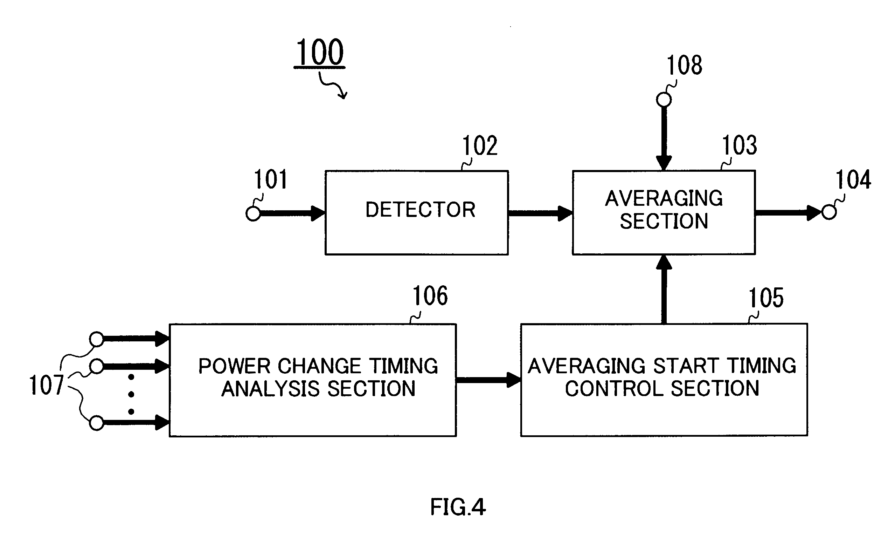

FIG.4 is a block diagram showing the configuration of a power measuring apparatus 100 according to Embodiment 1 of the present invention. The power measuring apparatus 100 is provided with a signal input terminal 101, a detector 102, an averaging section 103, a power measurement result output terminal 104, an averaging start timing control section 105, a power change timing analysis section 106, a power change timing information input terminal 107 and an averaging time setting input terminal 108. The power measuring apparatus 100 is normally used incorporated in a radio communication apparatus such as a base station and mobile station which make up a radio communication system.

The signal input terminal 101 receives an input signal obtained by code division multiplexing a plurality of channels having different power level change periods from a splitter (not shown), etc. The input signal input to the signal input terminal 101 is immediately input to the detector 102.

The detector 102 converts the power level of the input signal from the signal input terminal 101 to a voltage and inputs the converted power level signal to the averaging section 103.

When the averaging section 103 receives an averaging start timing signal from the averaging start timing control section 105, it starts measuring the power level of the power level signal input from the detector 102. Furthermore, the averaging section 103 stores the measured value for a power averaging time $T_S$ notified from the averaging time setting input terminal 108 and calculates a segment mean value of the power level after a lapse of the power averaging time $T_S$. Then, the averaging section 103 outputs the segment mean value of the calculated power level to the power measurement result output terminal 104.

When a longest segment identified by the power change timing analysis section 106 arrives, the averaging start timing control section 105 inputs an averaging start timing signal to the averaging section 103 based on information input from the power change timing analysis section 106.

The power change timing analysis section 106 receives information on the timing at which the power level of each channel of an input signal obtained by code division multiplexing a plurality of channels changes through the power change timing information input terminal 107. The power change timing analysis section 106 calculates a period during which the power level of a preset reference channel changes based on the information from the power change timing information input terminal 107, analyzes a timing at which the power level of each channel changes during that one period and identifies the longest segment during which the total signal power level does not change. Then, the power change timing analysis section 106 inputs the information on the identified longest segment to the averaging start timing control section 105.

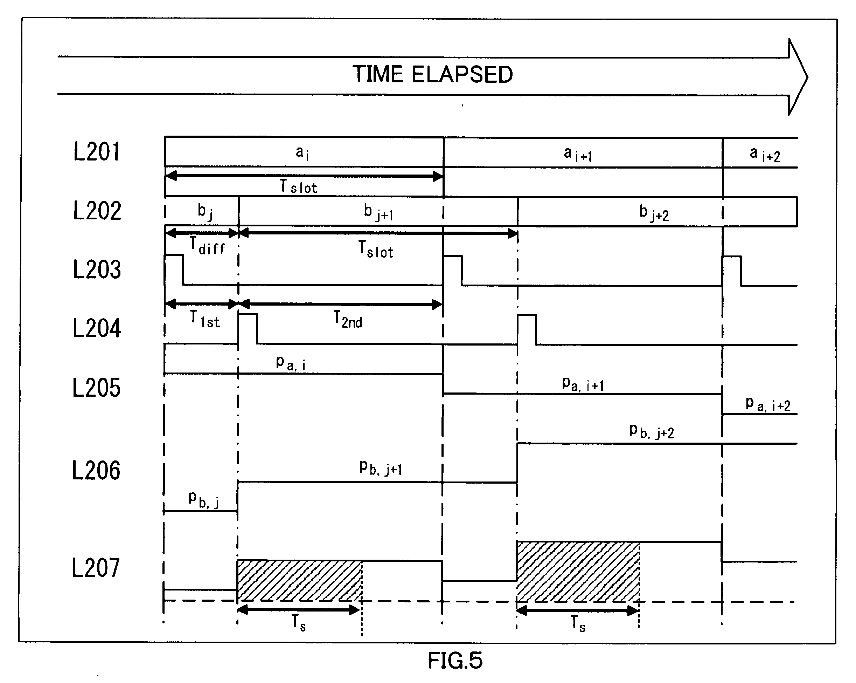

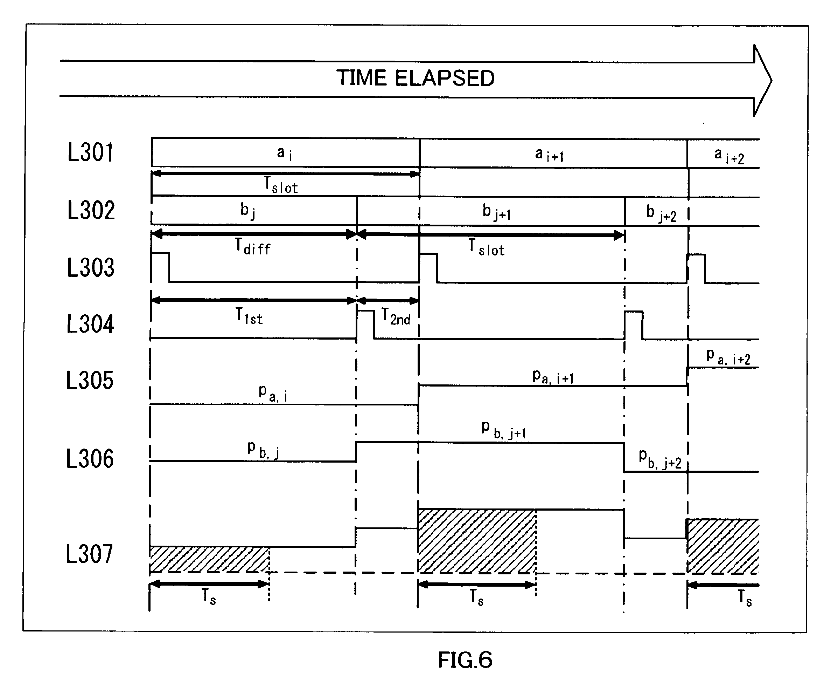

FIG.5 and FIG.6 show the power level, etc., of each slot of a signal obtained by code division multiplexing a plurality of channels having different periods or timings at which their power levels change. In FIG.5 and FIG.6, line L201 and line L301 show the slot configuration of channel A, line L202 and line L302 show the slot configuration of channel B, line L203 and line L303 show the slot synchronization signal of channel A, line L204 and line L304 show the slot synchronization signal of channel B, line L205 and line L305 show the power level of each slot of channel A, line L206 and line L306 show the power level of each slot of channel B, and line L207 and line L307 show the power level of a signal obtained by code division multiplexing the slot of channel A and the slot of channel B, that is, the total signal power level.

In FIG.5 and FIG.6, line L201 and line L301 are provided with slot numbers $a_i$, $a_{i+1}$, $a_{i+2}$ of channel A and line L202 and line L302 are provided with slot numbers $b_j$, $b_{j+1}$, $b_{j+2}$ of channel B. Furthermore, in FIG.5 and FIG. 6, $T_{slot}$ denotes slot lengths of channel A and channel B, $T_{diff}$ denotes the time difference between slots boundaries of channel A and channel B, and $T_{1st}$ and $T_{2nd}$ denote segments in which the total signal power level does not change relative to the slot of channel A. Furthermore, in FIG.5 and FIG.6, line L205 and line L305 show power levels $p_{a,i}$, $p_{a,i+1}$, $p_{a,i+2}$ of respective slots of channel A, line L206 and line L306 show power levels $p_{b,j}$, $p_{b,j+1}$, $p_{b,j+2}$ of respective slots of channel B, and line L207 and line L307 show the total signal power level and power averaging time $T_S$ which change depending on the multiplexing mode of slots of channel A and slots of channel B.

Next, the operation of the power measuring apparatus 100 will be explained more specifically with reference to FIG.4, FIG.5 and FIG.6 as appropriate. When the information on the timings at which the power levels of a plurality of channels to be code division multiplexed on an input signal change is input from the power change timing information input terminal 107 to the power change timing analysis section 106, the power change timing analysis section 106 analyzes the timings at which the power levels of the respective channels change within one period (1 slot) during which the power level of a preset reference channel (assumed to be channel A) changes and identifies the longest segment in which the total signal power level does not change based on the analysis result. The information on this identified longest segment is input from the power change timing analysis section 106 to the averaging start timing control section 105. Based on the information on the longest segment input, the averaging start timing control section 105 inputs the averaging start timing signal to the averaging section 103 when the longest segment starts. Then, when this averaging start timing signal is input, the averaging section 103 starts averaging of the power level signal from the detector 102. Here, in the case of FIG.5, since $T_{1st} \leqq T_{2nd}$ with respect to slot $a_i$, $T_{2nd}$ becomes the longest segment and the averaging section 103 starts averaging at the beginning of $T_{2nd}$. Furthermore, likewise in the case of FIG.6, since $T_{1st} > T_{2nd}$, the averaging section 103 starts averaging at the beginning of $T_{1st}$. The averaging section 103 that has started averaging of the power level signal from the detector 102 accumulates the measured values for the preset power averaging time $T_S$ notified from the averaging time setting input terminal 108 and calculates a segment mean value of the power level immediately after a lapse of the power averaging time $T_S$. Then, the averaging section 103 inputs the segment mean value of the calculated power level to the power measurement result output terminal 104.

FIG.5 and FIG.6 illustrate the case with two channels, but the power measuring apparatus 100 can also be used when there are three or more channels and the period during which the power level changes differs from one channel to another.

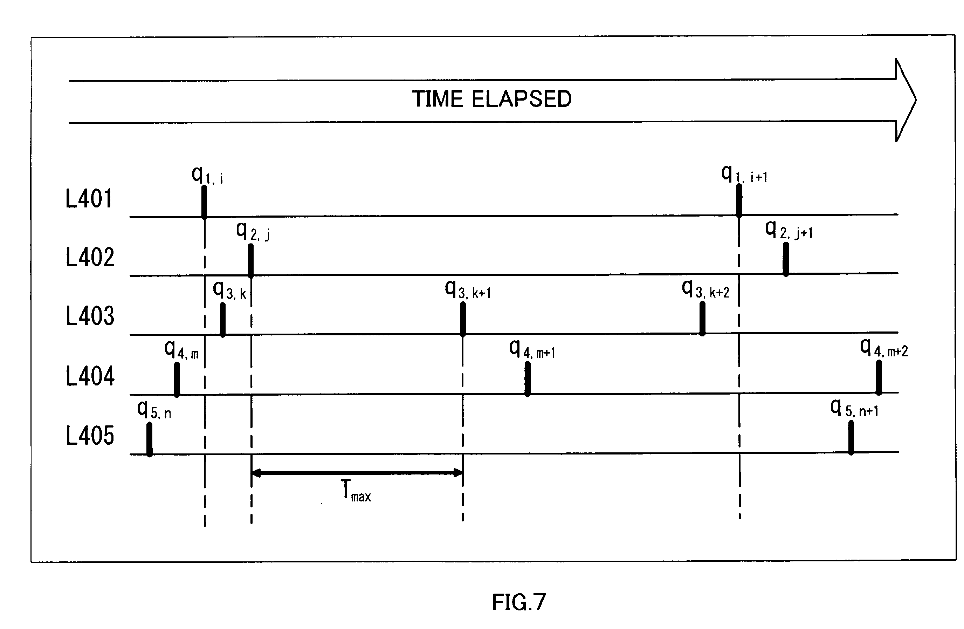

Of five channels having different periods at which their power levels change, FIG.7 shows timings at which the power levels of the respective channels change. In FIG.7, suppose the period at which the power level of each channel changes is constant. In FIG.7, line L401 shows the timing at which the power level of the first channel changes, line L402 shows the timing at which the power level of the second channel changes, line L403 shows the timing at which the power level of the third channel changes, line L404 shows the timing at which the power level of the fourth channel changes, and line L405 shows the timing at which the power level of the fifth channel changes. In FIG.7, $q_{1,i}$ and $q_{1,i+1}$ shown on line L401 show the timings at which the ith and (i+1)th power levels of the first channel change, likewise $q_{2,j}$ and $q_{2,j+1}$ show the timings at which the jth and (j+1)th power levels of the second channel change, likewise $q_{3,k}$, $q_{3,k+1}$ and $q_{3,k+2}$ show the timings at which the kth, (k+1)th and (k+2)th power levels of the third channel change, likewise $q_{4,m}$, $q_{4,m+1}$ and $q_{4,m+2}$ show the timings at which the mth, (m+1)th and (m+2)th power levels of the fourth channel change, and likewise $q_{5,n}$ and $q_{5,n+1}$ show the timings at which the nth and (n+1)th power levels of the fifth channel change.

Assuming that the reference channel is the first channel, the longest segment ($T_{max}$) during which the total signal power level does not change between $q_{1,i}$ and $q_{1,i+1}$ shown on line L401 is a segment between $q_{2,j}$ and $q_{3,k+1}$. Then, the averaging section 103 starts averaging at the timing at which $q_{2,j}$ which is the beginning of this longest segment arrives.

Thus, according to the power measuring apparatus 100 in this embodiment, the averaging start timing control section 105 causes the averaging section 103 to start averaging the power level in synchronization with the longest segment during which the total signal power level of the input signal does not change, and therefore it is possible to accurately measure the power level of an input signal obtained by code division multiplexing a plurality of channels whose power levels change at different periods or timings.

(Embodiment 2)

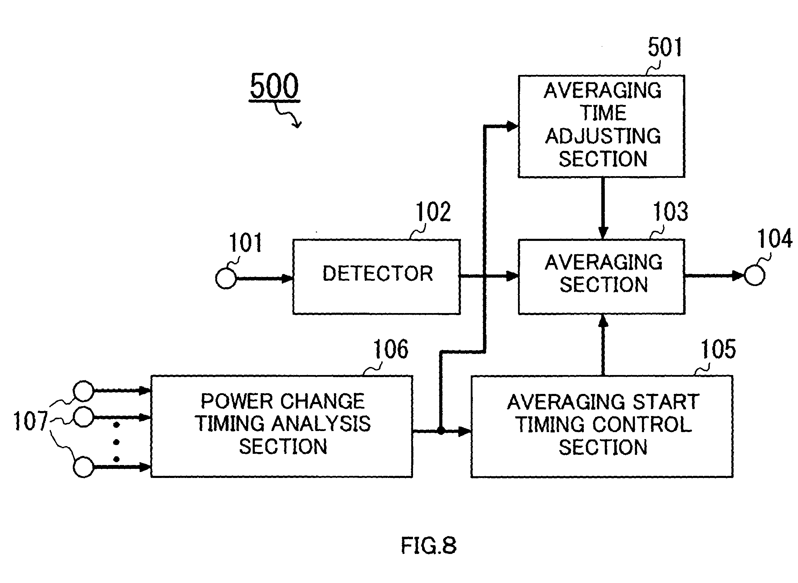

FIG.8 is a block diagram showing the configuration of a power measuring apparatus 500 according to Embodiment 2 of the present invention. The power measuring apparatus 500 is provided with all the components of the power measuring apparatus 100 according to Embodiment 1 and further provided with an averaging time adjusting section 501. Therefore, since most of the components of the power measuring apparatus 500 demonstrate functions similar to those of the components of the power measuring apparatus 100, explanations thereof will be omitted to avoid redundancy.

Based on information on the time length of the longest segment during which the total signal power level input from the power change timing analysis section 106 does not change, the averaging time adjusting section 501 determines a time which is shorter than this time length and enough to calculate a segment mean value of power levels and notifies the averaging section 103 of the determined time, that is, power averaging time $T_S$.

Next, the operation of the power measuring apparatus 500 will be explained with reference to FIG.8 as appropriate. When the power change timing analysis section 106 identifies the longest segment, the information on the identified longest segment is input from the power change timing analysis section 106 to the averaging start timing control section 105 and averaging time adjusting section 501. This information on the longest segment also includes information on the time length of the longest segment and when this information on the longest segment is input, the averaging time adjusting section 501 determines a power averaging time $T_S$ which is shorter than the longest segment and enough to calculate the segment mean value of the power level and notifies the averaging section 103 of the determined power averaging time $T_S$. Then, when the notified power averaging time $T_S$ elapses, the averaging section 103 immediately terminates averaging of the reception level of the input signal.

According to the power measuring apparatus 500 of this embodiment, the averaging time adjusting section 501 sets the power averaging time $T_S$ to a time equal to or shorter than the longest segment during which the power level of the input signal does not change according to the situation in which the power level of the input signal changes, and therefore it is possible to accurately measure the power level of the input signal all the time even if the longest segment changes.

(Embodiment 3)

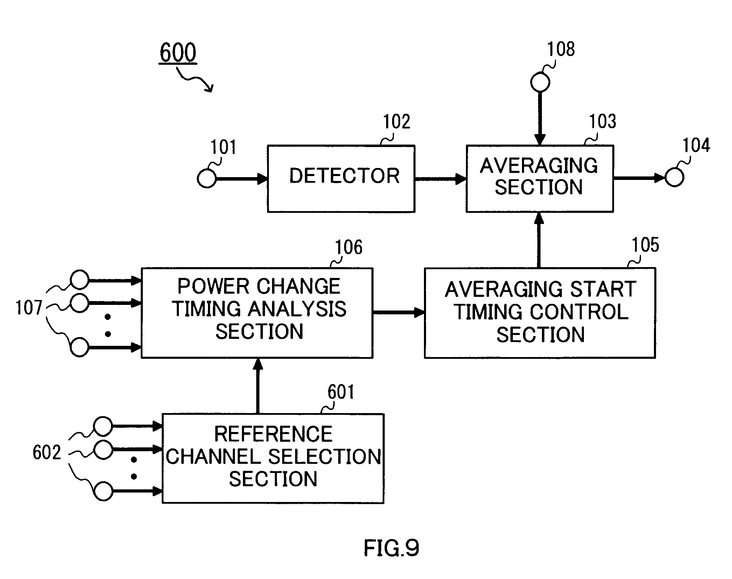

FIG.9 is a block diagram showing the configuration of a power measuring apparatus 600 according to Embodiment 3 of the present invention. The power measuring apparatus 600 is provided with all the components of the power measuring apparatus 100 according to Embodiment 1 and further provided with a reference channel selection section 601 and an information input terminal 602. Therefore, since most of the components of the power measuring apparatus 600 demonstrate functions similar to those of the components of the power measuring apparatus 100, explanations of the components demonstrating the similar functions will be omitted to avoid redundancy.

Next, the operation of the power measuring apparatus 600 will be explained with reference to FIG.9 as appropriate. The reference channel selection section 601 selects a reference channel based on information (period during which the power level changes, etc.) such as the characteristic of each channel input to the information input terminal 602 and notifies the power change timing analysis section 106 of the selected reference channel.

Therefore, according to the power measuring apparatus 600 in this embodiment, the reference channel selection section 601 selects a channel which has a dominant influence on, for example, the power level of the input signal from among a plurality of channels multiplexed on the input signal as a reference channel according to the situation in which the power level of the input signal changes and notifies the power change timing analysis section 106 of the reference channel, and therefore the averaging section 103 can measure the segment mean value of the power level of the input signal simply and accurately even if the level of influence of each channel on the input signal changes.

The power measuring apparatus 500 in Embodiment 2 may also be provided with the reference channel selection section 601 and information input terminal 602. In this way, the averaging time adjusting section 501 sets the power averaging time $T_S$ based on the reference channel selected by the reference channel selection section 601, and therefore, it is possible to improve the measuring accuracy of the power level of an input signal output from the power measurement result output terminal 104 even when the level of influence of each channel on the input signal changes.

(Embodiment 4)

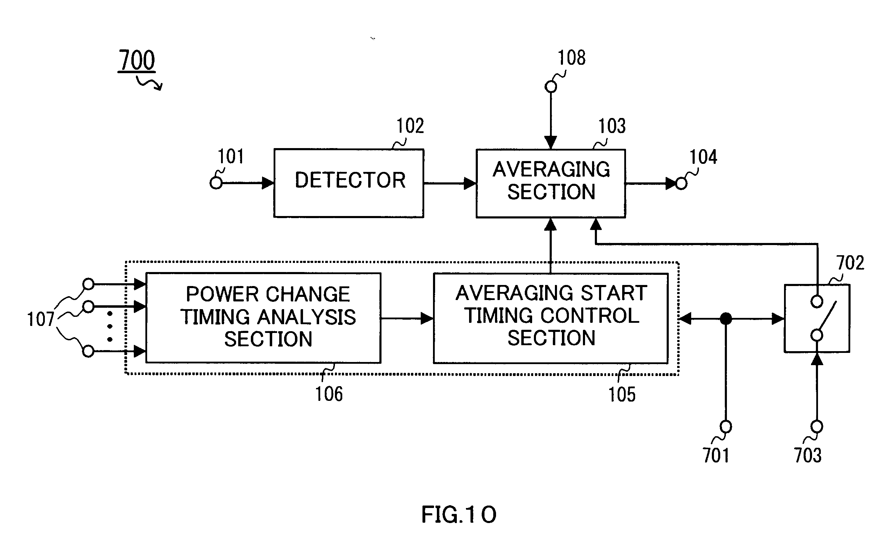

FIG.10 is a block diagram showing the configuration of a power measuring apparatus 700 according to Embodiment 4 of the present invention. The power measuring apparatus 700 is provided with all the components of the power measuring apparatus 100 according to Embodiment 1 and further provided with a stop signal input terminal 701, a switching section 702 and an averaging start timing signal input terminal 703. Therefore, since most of the components of the power measuring apparatus 700 demonstrate functions similar to those of the components of the power measuring apparatus 100, explanations of the components demonstrating the similar functions will be omitted to avoid redundancy.

Next, the operation of the power measuring apparatus 700 will be explained with reference to FIG.10 as appropriate. When measuring the power level of an input signal obtained by code division multiplexing a plurality of channels having different periods or timings at which their power levels change, there may be a situation in which the number of channels to be code division multiplexed reduces or the periods and timings at which their power levels change coincide with each other so that it is necessary to only measure the power level of a single channel. In such a case, the operations of the averaging start timing control section 105 and power change timing analysis section 106 are unnecessary, and therefore it is preferable to stop these components.

Thus, when there is a situation in which the operations of the averaging start timing control section 105 and power change timing analysis section 106 are unnecessary, the power measuring apparatus 700 inputs a stop signal to the averaging start timing control section 105 and power change timing analysis section 106 through the stop signal input terminal 701, stops those operations, also inputs this stop signal to the switching section 702 and inputs a timing signal for starting averaging of the power level to the averaging section 103 through the averaging start timing signal input terminal 703.

The power measuring apparatus 700 according to this embodiment adopts the power measuring apparatus 100 according to Embodiment 1 as the basic configuration, but it is also possible to include the power measuring apparatus 500 according to Embodiment 2 or the power measuring apparatus 600 according to Embodiment 3 as the basic configuration instead of the power measuring apparatus 100. Furthermore, when the power measuring apparatus 700 is provided with the power measuring apparatus 500 or power measuring apparatus 600 as the basic configuration, it is preferable to also stop the averaging time adjusting section 501 or reference channel selection section 601 together when stopping the averaging start timing control section 105 and power change timing analysis section 106.

Thus,the power measuring apparatus 700 according to this embodiment stops unnecessary operation of the components and provides the averaging section 103 with a signal necessary for averaging of the power level of an input signal through the switching section 702 as appropriate, and can thereby reduce power consumption of the power measuring apparatus 700 according to the situation in which the power level of the input signal changes.

(Embodiment 5)

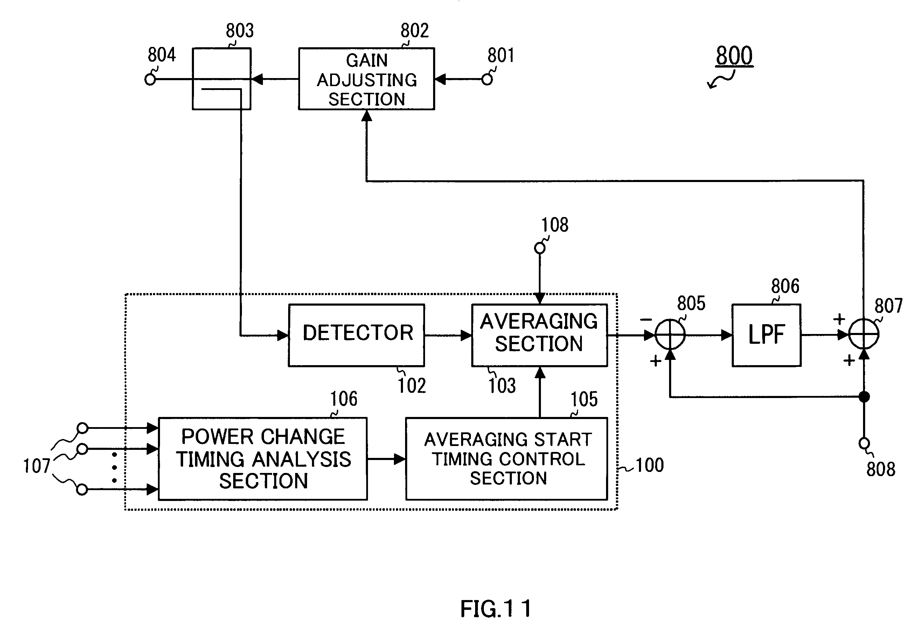

FIG.11 is a block diagram showing the configuration of a power control apparatus 800 according to Embodiment 5 of the present invention. The power control apparatus 800 is provided with the power measuring apparatus 100 according to Embodiment 1, a signal input terminal 801, a gain adjusting section 802, a splitter 803, a signal output terminal 804, a subtraction section 805, a low pass filter (LPF) 806, an addition section 807 and a reference level input terminal 808. The power control apparatus 800 will be explained with reference to drawings as appropriate, but explanations of the power measuring apparatus 100 will be omitted to avoid redundancy.

The signal input terminal 801 receives a signal obtained by code division multiplexing a plurality of channels having different periods or timings at which their power levels change. The signal input to the signal input terminal 801 is immediately input to the gain adjusting section 802.

The gain adjusting section 802 adjusts the gain according to a gain control value provided from the addition section 807 as appropriate and amplifies the input signal from the signal input terminal 801 with the adjusted gain. Furthermore, the gain adjusting section 802 inputs the amplified input signal to the splitter 803.

The splitter 803 splits the amplified input signal from the gain adjusting section 802, inputs the split input signal to the detector 102 and at the same time outputs the input signal to the signal output terminal 804.

The subtraction section 805 subtracts a segment mean value calculated by the averaging section 103 from a reference level input through the reference level input terminal 808 and inputs the difference obtained through the subtraction to the low pass filter 806.

The low pass filter 806 prevents the difference obtained through the subtraction to be input from the subtraction section 805 to addition section 807 from drastically changing.

The addition section 807 adds the difference obtained through the subtraction by the subtraction section 805 input through the low pass filter 806 to the reference level input through the reference level input terminal 808, calculates a gain control value and inputs the calculated gain control value to the gain adjusting section 802.

Next, the operation of the power control apparatus 800 will be explained with reference to FIG.11 as appropriate. An input signal obtained by code division multiplexing a plurality of channels input to the signal input terminal 801 is amplified at the gain adjusting section 802 with a gain adjusted according to the gain control value from the addition section 807 and then branched by the splitter 803. One portion of the input signal branched by the splitter 803 is output to the signal output terminal 804 and the other portion is input to the detector 102 of the power measuring apparatus 100. A segment mean value of a power level calculated by being subjected to predetermined processing by the detector 102 and averaging section 103 is input to the subtraction section 805, compared with the reference level from the reference level input terminal 808 and the comparison result is input to the addition section 807 through the low pass filter 806. The addition section 807 adds the comparison result at the subtraction section 805 to the reference level and the gain control value is supplied to the gain adjusting section 802. Then, the gain adjusting section 802 observes the gain control values supplied from the addition section 807 on a time-series basis and adjusts the gain through feedback according to a rise or fall of the gain control value so that the input signal from the signal input terminal 801 becomes a desired power level after amplification.

The power control apparatus 800 according to this embodiment is provided with the power measuring apparatus 100 according to Embodiment 1, but the power control apparatus 800 can also be provided with the power measuring apparatus 500, 600 or 700 instead of the power measuring apparatus 100.

Therefore, the power control apparatus 800 according to this embodiment measures the power level of an input signal accurately through the power measuring apparatus 100, and can thereby amplify the input signal to a desired power level.

(Embodiment 6)

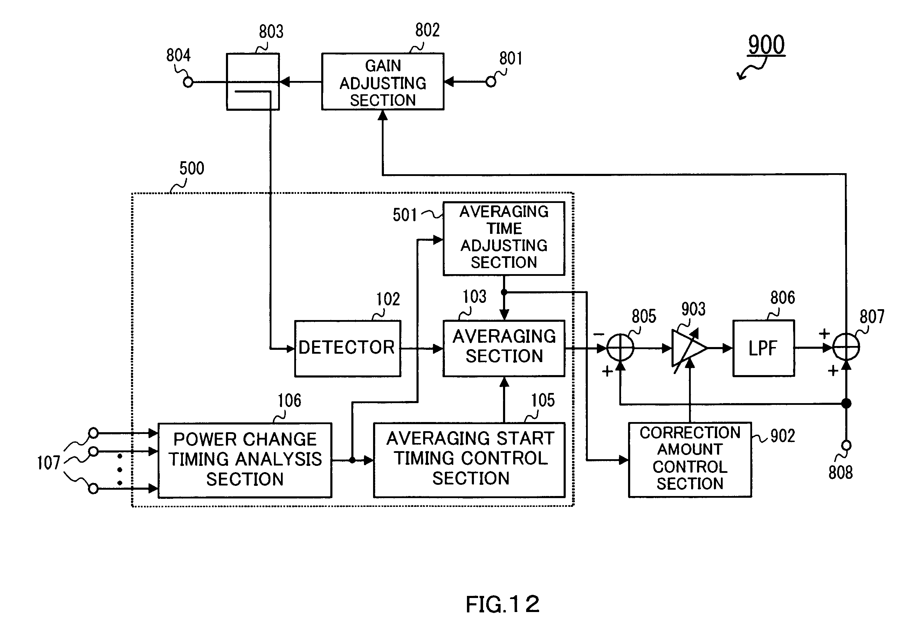

FIG.12 is a block diagram showing the configuration of a power control apparatus 900 according to Embodiment 6 of the present invention. The power control apparatus 900 is the power control apparatus 800 according to Embodiment 5 provided with the power measuring apparatus 500 instead of power measuring apparatus 100 and further provided with a correction amount control section 902 and a level correction section 903. Therefore, most of the components of the power control apparatus 900 demonstrate functions similar to those of the components of the power control apparatus 800 and power measuring apparatus 500, and therefore explanations of the components demonstrating the similar functions will be omitted to avoid redundancy.

The correction amount control section 902 receives information on a power averaging time $T_S$ from the averaging time adjusting section 501. When the correction amount control section 902 decides, based on the information provided, that the power averaging time $T_S$ is short and the segment mean value of the power level calculated by the averaging section 103 is not sufficiently accurate, the correction amount control section 902 controls the level correction section 903 so as to correct the difference between the segment mean value input from the subtraction section 805 and a reference level to be reduced and input the corrected value to the addition section 807 through the low pass filter 806.

Therefore, in the power control apparatus 900 according to this embodiment, when the accuracy of a segment mean value of a power level calculated by the averaging section 103 is insufficient, the correction amount control section 902 and level correction section 903 correct the difference between the segment mean value and reference level to a small value, and therefore it is possible to avoid the gain used by the gain adjusting section 802 from violently fluctuating based on a segment mean value with low reliability and prevent the amplification state at the gain adjusting section 802 from drastically changing.

(Embodiment 7)

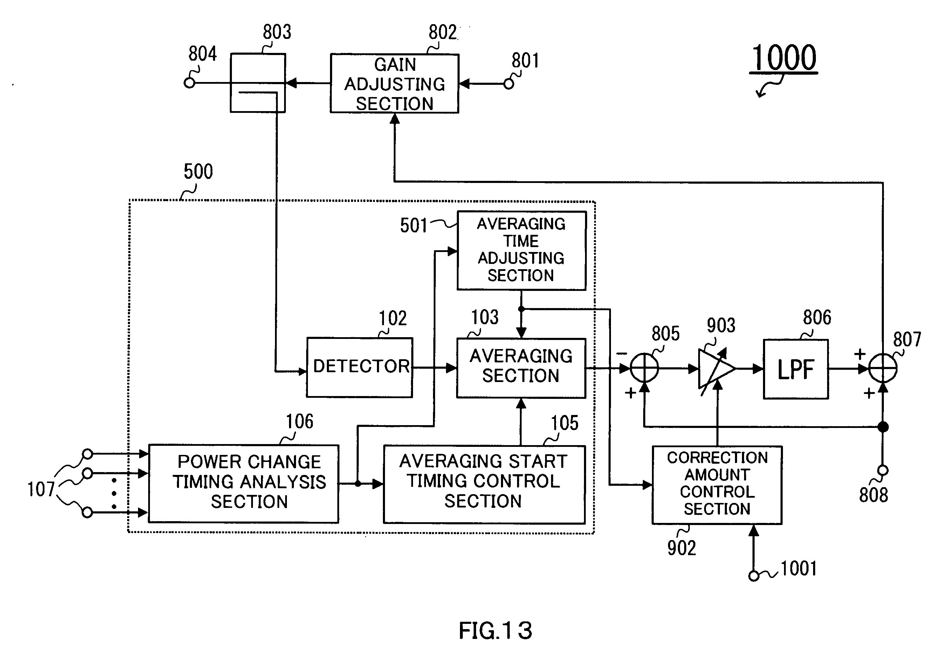

FIG.13 is a block diagram showing the configuration of a power control apparatus 1000 according to Embodiment 7 of the present invention. The power control apparatus 1000 is the power control apparatus 900 according to Embodiment 6 provided with an information input terminal 1001 that inputs characteristic information on an input signal to a correction amount control section 902. Therefore, most of the components of the power measuring apparatus 1000 demonstrate functions similar to those of the components of the power control apparatus 900, and therefore explanations of the components demonstrating the similar functions will be omitted to avoid redundancy.

Here, the operation of the power control apparatus 1000 and the operations of the correction amount control section 902 and level correction section 903 in particular will be explained with reference to FIG.13. The information indicating the characteristic of an input signal input to the signal input terminal 801, for example, information indicating the modulation scheme and modulation rate, etc., is input from the information input terminal 1001 to the correction amount control section 902. The correction amount control section 902 newly sets a reference about a power averaging time $T_S$ used to decide the accuracy of a mean value of a power level based on the information input. Then, the correction amount control section 902 controls the correction amount at the level correction section 903 based on the newly set reference.

Therefore, the power control apparatus 1000 according to this embodiment can adjust the reference applied to the power averaging time $T_S$ in deciding the accuracy of the segment mean value of the power level according to the modulation rate, etc., of an input signal as appropriate in addition to the effect exerted by the power control apparatus 900 and thereby maintain the gain used to amplify the input signal at the gain adjusting section 802 in an optimum state. For example, the power control apparatus 1000 decreases the power averaging rate $T_S$ when the modulation rate of an input signal is high and increases the power averaging rate $T_S$ when the modulation rate is low.

(Embodiment 8)

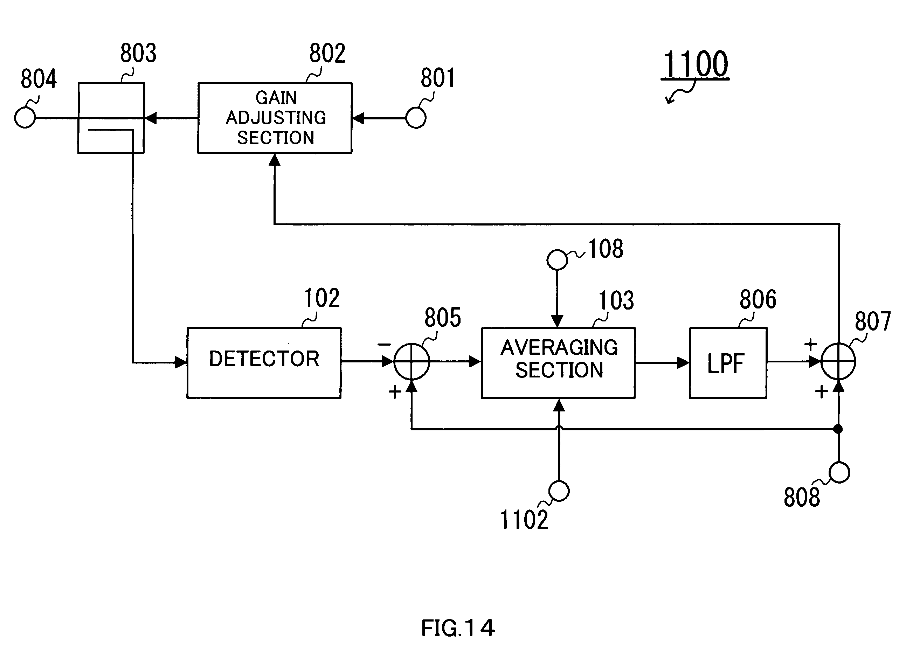

FIG.14 is a block diagram showing the configuration of a power control apparatus 1100 according to Embodiment 8 of the present invention. The power control apparatus 1100 is the power control apparatus 800 according to Embodiment 5 with the subtraction section 805 relocated between the detector 102 and averaging section 103. Therefore, all the components of the power control apparatus 1100 demonstrate functions similar to those of the components of the power control apparatus 800, and therefore explanations of the components demonstrating the similar functions will be omitted to avoid redundancy. In FIG.14, the averaging start timing control section 105, power change timing analysis section 106 and power change timing information input terminal 107 are omitted.

The power control apparatus 1100 compares a power level signal from the detector 102 with a reference level from the reference level input terminal 808 and the averaging section 103 performs averaging on the difference obtained by subtracting the power level signal from the reference level. Therefore, the power control apparatus 1100 according to this embodiment averages the difference between the reference level and the detected power level even if the total signal power level of the input signal changes within the power averaging time $T_S$, and therefore it is possible to perform more accurate power control without being affected by changes of the total signal power level.

(Reference Example 1)

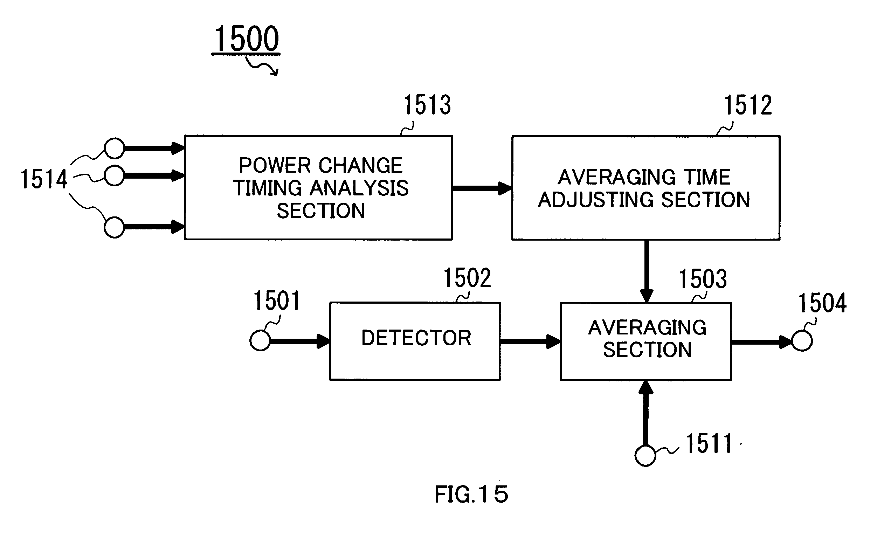

FIG.15 is a block diagram showing the configuration of a power measuring apparatus 1500 according to Reference Example 1. The power measuring apparatus 1500 is provided with a signal input terminal 1501, a detector 1502, an averaging section 1503, a power measurement result output terminal 1504, an averaging start timing signal input terminal 1511, an averaging time adjusting section 1512, a power change timing analysis section 1513 and a power change timing information input terminal 1514. The power measuring apparatus 1500 is normally used incorporated in a radio communication apparatus such as a base station and mobile station making up a radio communication system.

The signal input terminal 1501 receives an input signal obtained by code division multiplexing a plurality of channels having different periods at which power levels change from a splitter (not shown), etc. The input signal input to the signal input terminal 1501 is immediately input to the detector 1502.

The detector 1502 converts the power level of the input signal from the signal input terminal 1501 to a voltage and inputs the converted power level signal to the averaging section 1503.

When an averaging start timing signal is input from the averaging start timing signal input terminal 1511, the averaging section 1503 starts to measure the power level of the power level signal input from the detector 1502. Furthermore, the averaging section 1503 stores the measured value for the power averaging time $T_S$ notified from the averaging time adjusting section 1512 and calculates a segment mean value of the power level immediately after the lapse of the power averaging time $T_S$. Then, the averaging section 1503 outputs the calculated segment mean value of the power level to the power measurement result output terminal 1504.

The averaging time adjusting section 1512 calculates the period during which the total signal power level does not change at an arbitrary timing based on the information on the timing at which the total signal power level of the input signal obtained by code division multiplexing a plurality of channels input from the power change timing analysis section 1513 changes. Then, the averaging time adjusting section 1512 sets a period which is equal to or shorter than a period during which this calculated power level does not change and notifies the averaging section 1503 of the set period as the power averaging time $T_S$.

The power change timing analysis section 1513 receives information on a timing at which the power level of each channel of the input signal obtained by code division multiplexing a plurality of channels changes through the power change timing information input terminal 1514. The power change timing analysis section 1513 analyzes a timing at which the power level of each channel changes during one period of the change period (normally 1 slot) of the power level of a preset reference channel based on the information from the power change timing information input terminal 1514 and calculates the length of the segment in which the total signal power level of the input signal at an arbitrary timing does not change based on the analysis result. Then, the power change timing analysis section 1513 inputs the information on the calculated total signal power level of the input signal to the averaging time adjusting section 1512.

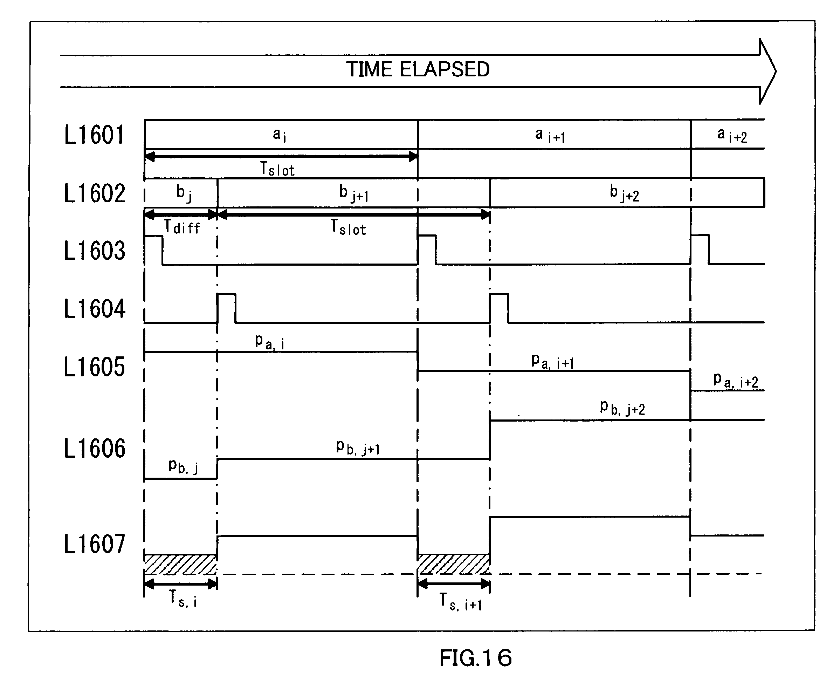

FIG.16 shows the power level of each slot, etc., of an input signal obtained by code division multiplexing a plurality of channels having different periods or timings at which their power levels change. In FIG.16, line L1601 shows the slot configuration of channel A, line L1602 the slot configuration of channel B, line L1603 shows the slot synchronization signal of channel A, line L1604 shows the slot synchronization signal of channel B, line L1605 shows the power level of each slot of channel A, line L1606 shows the power level of each slot of channel B, and line L1607 shows the power level when a slot of channel A and a slot of channel B are code division multiplexed, that is, total signal power level. Furthermore, in FIG.16, line L1601 is provided with slot numbers $a_i$, $a_{i+1}$, $a_{i+2}$ of channel A and line L1602 is provided with slot numbers $b_j$, $b_{j+1}$, $b_{j+2}$ of channel B. Furthermore, in FIG.16, $T_{slot}$ shows the slot length of channel A and channel B, $T_{diff}$ shows the time difference between the slot boundaries of channel A and channel B. Furthermore, in FIG.16, line L1605 shows power levels $p_{a,i}$, $p_{a,i+1}$, $p_{a,i+2}$ of each slot of channel A, line L1606 shows power levels $p_{b,j}$, $p_{b,j+1}$, $p_{b,j+2}$ of each slot of channel B, line L1607 shows the total signal power level and power averaging times $T_{S,i}$, $T_{S,i+1}$ which change according to the multiplexing mode of slots of channel A and slots of channel B.

Next, the operation of the power measuring apparatus 1500 will be explained with reference to FIG.15 and FIG.16 as appropriate. The power change timing analysis section 1513 analyzes a timing at which the power level of each channel changes during one period of the change period (1 slot) of the power level of a reference channel (assumed to be channel A) and calculates a time difference between a timing at which the power level of the reference channel changes and an immediately following timing at which the power level of any channel changes. Then, the power change timing analysis section 1513 notifies the averaging time adjusting section 1512 of this calculated time difference. Notified of this time difference, the averaging time adjusting section 1512 sets a period which is equal to or shorter than the time difference and notifies the averaging section 1503 of the set period as power averaging times $T_{S,i}$, $T_{S,i+1}$. Notified of the power averaging times $T_{S,i}$, $T_{S,i+1}$, the averaging section 1503 averages the power level signal input from the detector 1502 over the power averaging times $T_{S,i}$, $T_{S,i+1}$ as the measuring segments. Then, the averaging section 1503 outputs the segment mean value of the power level signal calculated through segment-averaging to the power measurement result output terminal 1504. In the case of FIG.16, suppose the time difference is $T_{diff}$ and the power averaging times $T_{S,i}$, $T_{S,i+1}$ are also $T_{diff}$.

The example shown in FIG. 16 has explained the case where the power measuring apparatus 1500 receives a signal obtained by code division multiplexing two channels having the same period but different timings at which their power levels change, but it is also possible to adapt the present invention so that the power measuring apparatus 1500 receives a signal obtained by code division multiplexing three or more channels having different periods and timings at which their power levels change.

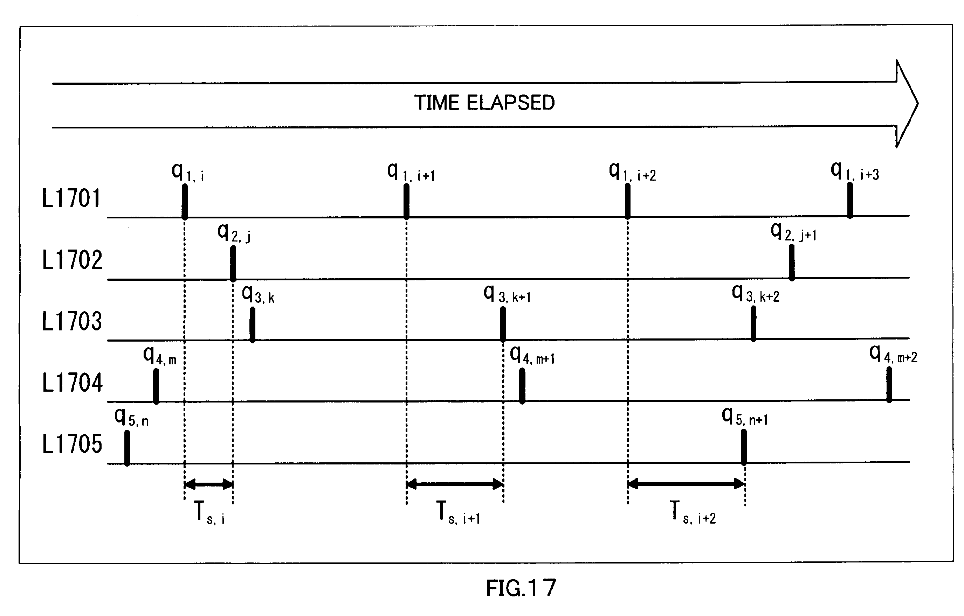

FIG.17 shows timings of slot synchronization signals for five channels having different periods and timings at which their power levels change. In FIG.17, line L1701 shows timings at which the power level of the first channel changes, line L1702 shows timings at which the power level of the second channel changes, line L1703 shows timings at which the power level of the third channel changes, line L1704 shows timings at which the power level of the fourth channel changes, and line L1705 shows timings at which the power level of the fifth channel changes. Furthermore, $q_{1,i}$, $q_{1,i+1}$, $q_{1,i+2}$, $q_{1,i+3}$ on line L1701 show timings at which the ith, (i+1)th, (i+2)th, (i+3) th power levels of the first channel change, $q_{2,j}$, $q_{2,j+1}$ on line L1702 show timings at which the jth, (j+1) th power levels of the second channel change, $q_{3,k}$, $q_{3,k+1}$, $q_{3,k+2}$ on line L1703 show timings at which the kth, (k+1)th, (k+2)th power levels of the third channel change, $q_{4,m}$, $q_{4,m+1}$, $q_{4,m+2}$ on line L1704 show timings at which the mth, (m+1)th, (m+2)th power levels of the fourth channel change, and $q_{5,n}$, $q_{5,n+1}$ on line L1705 show timings at which the nth, (n+1)th power levels of the fifth channel change.

In FIG.17, suppose if the reference channel is, for example, the first channel, the timing at which the power level changes between $q_{1,i}$ to $q_{1,i+1}$ next to $q_{1,i}$ is $q_{2,j}$ and the segment $q_{1,i}$ to $q_{2,j}$ becomes a power averaging time $T_{s,i}$. Likewise, between $q_{1,i+1}$ to $q_{1,i+2}$, the segment $q_{1,i+1}$ to $q_{3,k+1}$ becomes a power averaging time $T_{S,i+1}$ and between $q_{1,i+2}$ to $q_{1,i+3}$, the segment $q_{1,i+2}$ to $q_{5,n+1}$ becomes a power averaging time $T_{S,i+2}$.

Thus, in the power measuring apparatus 1500 according to this reference example, the averaging time adjusting section 1512 and power change timing analysis section 1513 adaptively adjust the length of the power averaging time $T_S$ according to various modes of timing at which the total signal power level of the input signal changes, and therefore it is possible to accurately measure the power level of an input signal obtained by code division multiplexing a plurality of channels whose power levels change at different periods or timings all the time.

(Reference Example 2)

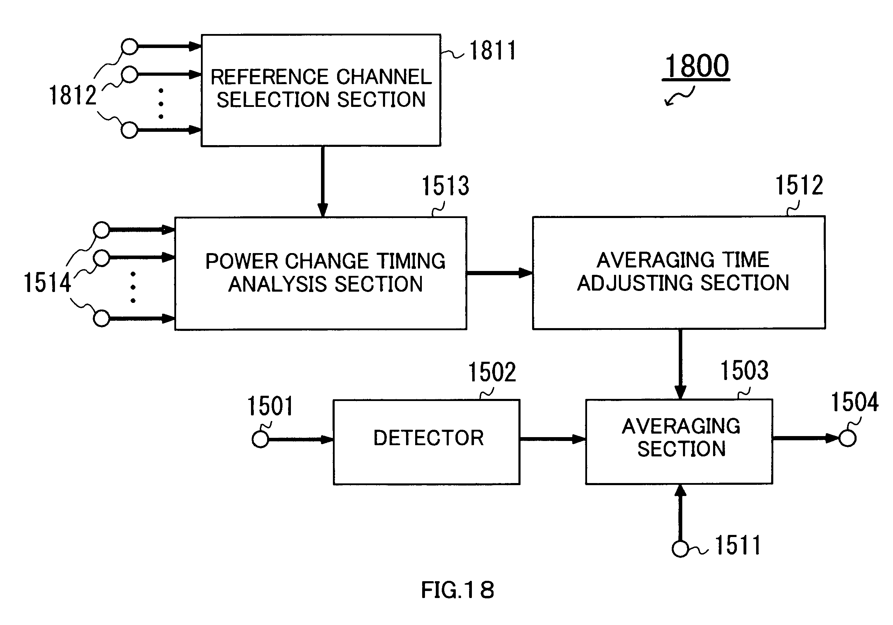

FIG.18 shows a block diagram showing the configuration of a power measuring apparatus 1800 according to Reference Example 2. The power measuring apparatus 1800 is provided with all the components of the power measuring apparatus 1500 according to Reference Example 1 and further provided with a reference channel selection section 1811 and an information input terminal 1812. Therefore, since most of the components of the power measuring apparatus 1800 demonstrate functions similar to those of the power measuring apparatus 1500, explanations of the components demonstrating the similar functions will be omitted to avoid redundancy.

Next, the operation of the power measuring apparatus 1800 will be explained with reference to FIG.18 as appropriate. The reference channel selection section 1811 selects a reference channel based on the characteristic information of each channel (period during which the power level changes, etc.) input to the information input terminal 1812 and notifies the power change timing analysis section 1513 of the selected reference channel.

Therefore, the power measuring apparatus 1800 according to this reference example selects the reference channel based on the characteristic information of each channel included in the input signal, and therefore even if the level of influence of each channel on the input signal changes, a correct reference channel is always selected and it is thereby possible to measure the power level of the input signal accurately.

(Reference Example 3)

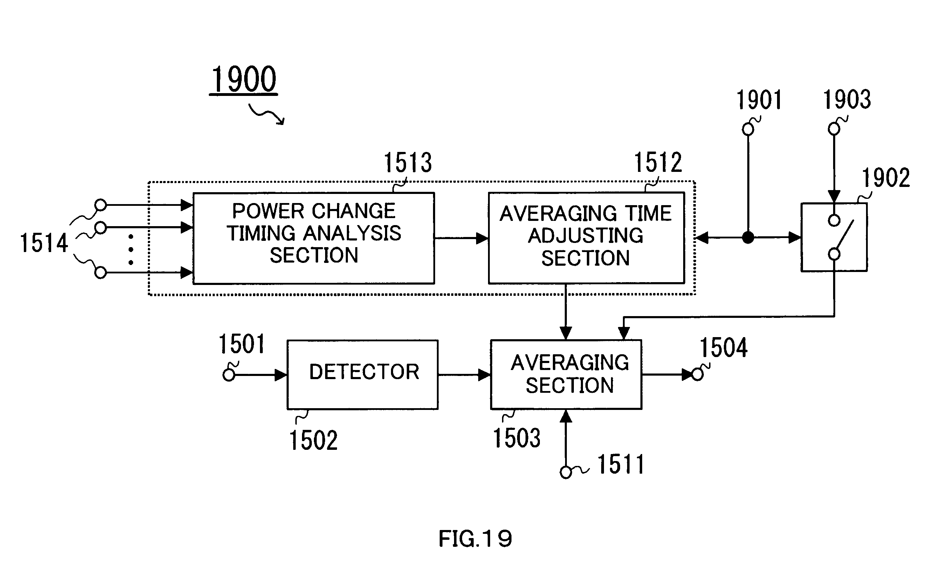

FIG.19 is a block diagram showing the configuration of a power measuring apparatus 1900 according to Reference Example 3. The powermeasuring apparatus 1900 is provided with all the components of the power measuring apparatus 1500 according to Reference Example 1 and further provided with a stop signal input terminal 1901, a switching section 1902 and an averaging time setting input terminal 1903. Therefore, since most of the components of the power measuring apparatus 1900 demonstrate functions similar to those of the power measuring apparatus 1500, explanations of the components demonstrating the similar functions will be omitted to avoid redundancy.

Next, the operation of the power measuring apparatus 1900 will be explained with reference to FIG.19 as appropriate. During measurement of the power level of an input signal obtained by code division multiplexing a plurality of channels having different periods or timings at which their power levels change, there may be a situation in which the number of channels to be code division multiplexed reduces or the periods and timings at which their power levels change coincide with each other so that it is necessary to only measure the power level of a single channel. In such a case, the operations of the averaging time adjusting section 1512 and power change timing analysis section 1513 become unnecessary, and therefore it is preferable to stop these components.

Thus, when there is no need to operate the averaging time adjusting section 1512 and power change timing analysis section 1513, the power measuring apparatus 1900 inputs a stop signal to the averaging time adjusting section 1512 and power change timing analysis section 1513 through the stop signal input terminal 1901 to stop those operations. The power measuring apparatus 1900 also inputs this stop signal to the switching section 1902 and inputs an averaging time setting signal including the power averaging time $T_S$ to the averaging section 1503 through the averaging time setting input terminal 1903.

The power measuring apparatus 1900 according to this reference example adopts the power measuring apparatus 1500 according to Reference Example 1 as the basic configuration, but it is also possible to incorporate the power measuring apparatus 1800 according to Reference Example 2 instead of the power measuring apparatus 1500. Furthermore, when the power measuring apparatus 1900 is provided with the power measuring apparatus 1800 as the basic configuration, it is preferable to stop the reference channel selection section 1811 together with the averaging time adjusting section 1512 and power change timing analysis section 1513.

Thus, the power measuring apparatus 1900 according to this reference example stops unnecessary operations of components and supplies a signal necessary for averaging of the power level of an input signal to the averaging section 1503 as appropriate through the switching section 1902, and can thereby reduce power consumption of the power measuring apparatus 1900 according to a situation in which the power level of the input signal changes.

(Reference Example 4)

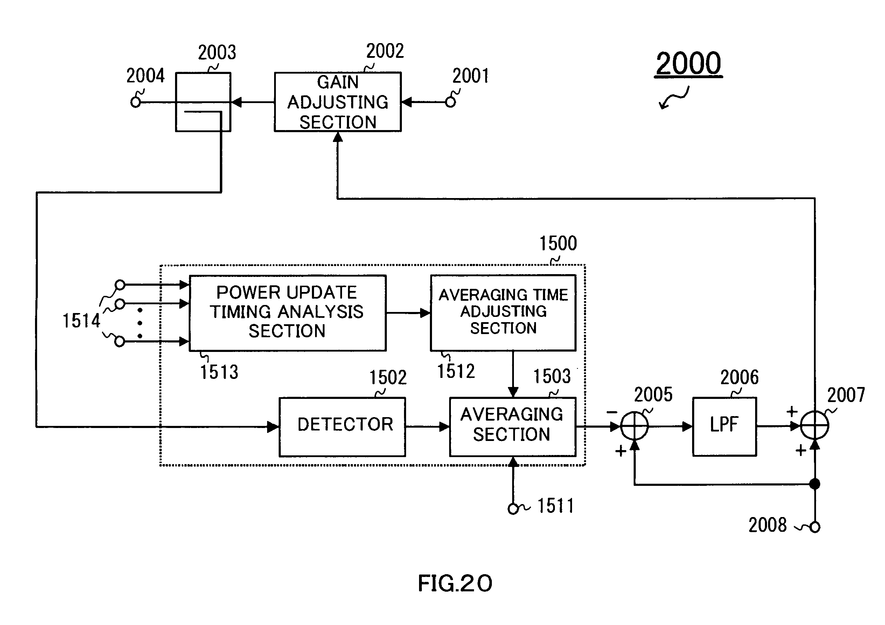

FIG.20 is a block diagram showing the configuration of a power measuring apparatus 2000 according to Reference Example 4. The power control apparatus 2000 is provided with the power measuring apparatus 1500 according to Reference Example 1, a signal input terminal 2001, a gain adjusting section 2002, a splitter 2003, a signal output terminal 2004, a subtraction section 2005, a low pass filter (LPF) 2006, an addition section 2007 and a reference level input terminal 2008. The power control apparatus 2000 will be explained below with reference to the drawings as appropriate, but explanations of the power measuring apparatus 1500 will be omitted to avoid redundancy.

The signal input terminal 2001 receives a signal obtained by code division multiplexing a plurality of channels having different periods or timings at which their power levels change. The signal input to the signal input terminal 2001 is immediately input to the gain adjusting section 2002.

The gain adjusting section 2002 adjusts the gain according to a gain control value provided from the addition section 2007 as appropriate and amplifies the input signal from the signal input terminal 2001 at the adjusted gain. Furthermore, the gain adjusting section 2002 inputs the amplified input signal to the splitter 2003.

The splitter 2003 splits the amplified input signal from the gain adjusting section 2002, inputs the split input signal to the detector 1502 and at the same time outputs the split input signal to the signal output terminal 2004.

The subtraction section 2005 subtracts a segment mean value calculated by the averaging section 1503 from a reference level input through the reference level input terminal 2008 and inputs the difference resulting from the subtraction to the low pass filter 2006.

The low pass filter 2006 prevents the difference resulting from the subtraction input from the subtraction section 2005 to the addition section 2007 from drastically fluctuating.

The addition section 2007 adds the difference resulting from the subtraction at the subtraction section 2005 input through the lowpass filter 2006 to the reference level input through the reference level input terminal 2008, calculates a gain control value and inputs the calculated gain control value to the gain adjusting section 2002.

Next, the operation of the power control apparatus 2000 will be explained with reference to FIG.20 as appropriate. The input signal obtained by code division multiplexing a plurality of channels input to the signal input terminal 2001 is amplified with a gain adjusted by the gain adjusting section 2002 according to the gain control value from the addition section 2007 and then split by the splitter 2003. Then, one portion of the input signal split by the splitter 2003 is output to the signal output terminal 2004 and the other portion is input to the detector 1502 of the power measuring apparatus 1500. The segment mean value of the power level calculated by being subjected to predetermined processing at the detector 1502 and averaging section 1503 is input to the subtraction section 2005, compared with the reference level from the reference level input terminal 2008 and the comparison result is input to the addition section 2007 through the low pass filter 2006. The addition section 2007 adds the comparison result at the subtraction section 2005 to the reference level and the gain control value is provided to the gain adjusting section 2002. Then, the gain adjusting section 2002 observes the gain control value provided from the addition section 2007 on a time-series basis and adjusts the gain through feedback so that the input signal from the signal input terminal 2001 becomes a desired power level after being amplified according to a rise or fall of the gain control value.

The power control apparatus 2000 according to this reference example is provided with the power measuring apparatus 1500 according to Reference Example 1, but it is also possible to incorporate the power measuring apparatus 1800 or power measuring apparatus 1900 instead of the power measuring apparatus 1500.

Thus, in the power control apparatus 2000 according to this reference example, the averaging time adjusting section 1512 can adjust the period during which the averaging section 1503 averages the power level of the input signal over a segment as appropriate, and therefore when the total signal power level of a signal obtained by multiplexing a plurality of channels having different periods or timings at which their power levels change is averaged and calculated over a segment, even when the length of the segment during which the total signal power level does not change varies in various ways due to the multiplexing mode of a plurality of channels, a power averaging time $T_S$ equal or shorter than the lengths of those segments is set, and therefore, it is possible to accurately measure the power level all the time and as a result, accurately amplify the input signal to a desired power level.

Furthermore, a radio communication apparatus provided with the power control apparatus 2000 according to this reference example can maintain the power level of an amplified transmission/reception signal within an appropriate range and thereby improve the communication quality.

(Reference Example 5)

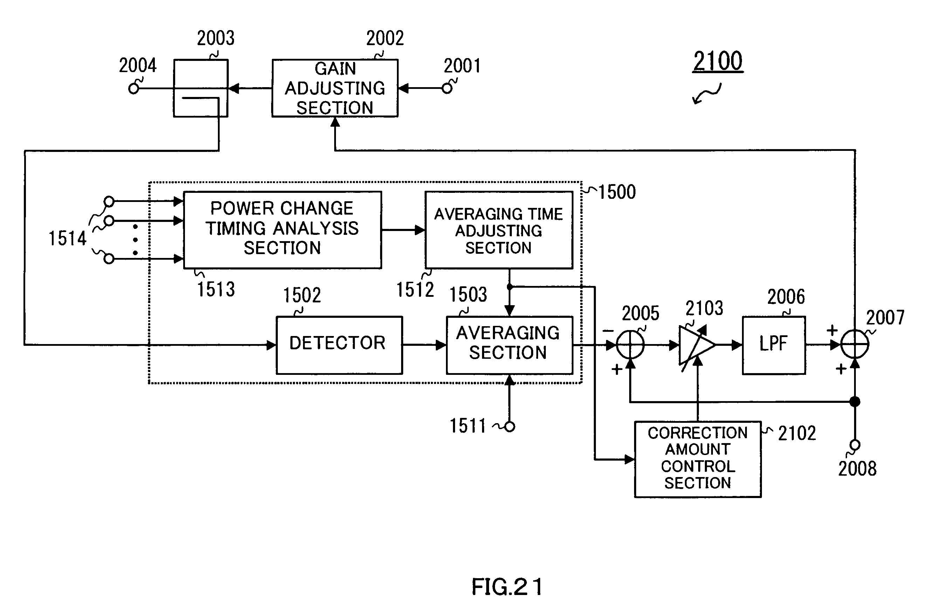

FIG.21 is a block diagram showing the configuration of a power control apparatus 2100 according to Reference Example 5. The power control apparatus 2100 is the power control apparatus 2000 according to Reference Example 4 provided with a correction amount control section 2102 and a level correction section 2103. Therefore, since most of the components of the power measuring apparatus 2100 demonstrate functions similar to those of the components of the power measuring apparatus 2000, explanations of the components demonstrating the similar functions will be omitted to avoid redundancy.

The correction amount control section 2102 is supplied with information on a power averaging time $T_S$ from the averaging time adjusting section 1512. When the correction amount control section 2102 decides, based on the information supplied, that the power averaging time $T_S$ is short and the accuracy of the segment mean value of the power level calculated by the averaging section 1503 is insufficient, the correction amount control section 2102 controls the level correction section 2103 so as to correct the difference between the segment mean value input from the subtraction section 2005 and reference level to be reduced. Then, the level correction section 2103 inputs the corrected value to the addition section 2007 through the low pass filter 2006.

Therefore, in the power control apparatus 2100 according to this reference example, when the accuracy of the segment mean value of the power level calculated by the averaging section 1503 is insufficient, the correction amount control section 2102 and level correction section 2103 correct the difference between the segment mean value and reference level to a smaller value, and therefore it is possible to avoid the gain used by the gain adjusting section 2002 from violently fluctuating based on the segment mean value with low reliability and consequently prevent the amplification state at the gain adjusting section 2002 from drastically fluctuating.

(Reference Example 6)

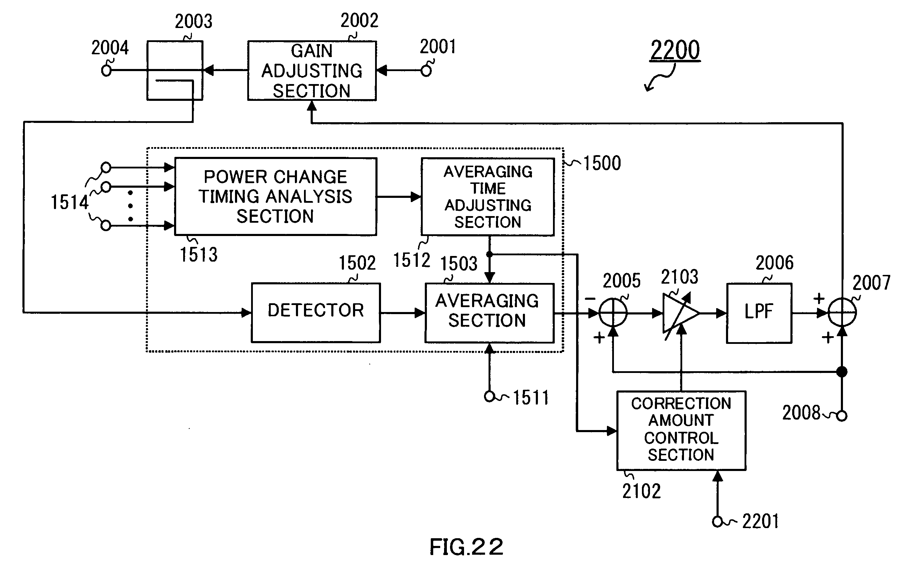

FIG.22 is a block diagram showing the configuration of a power control apparatus 2200 according to Reference Example 6. The power control apparatus 2200 is the power control apparatus 2100 according to Reference Example 5 further provided with an information input terminal 2201 that inputs characteristic information of an input signal to the correction amount control section 2102. Therefore, since most of the components of the power control apparatus 2200 demonstrate functions similar to those of the components of the power control apparatus 2100, explanations of the components demonstrating the similar functions will be omitted to avoid redundancy.

Here, the operation of the power control apparatus 2200, the operations of the correction amount control section 2102 and level correction section 2103 in particular will be explained with reference to FIG.22. Information indicating the characteristic of an input signal input to the signal input terminal 2001, for example, information indicating the modulation scheme and modulation rate, etc., is input from the information input terminal 2201 to the correction amount control section 2102. Based on the information input, the correction amount control section 2102 newly sets a reference about a power averaging time $T_S$ used to decide the accuracy of the mean value of the power level. Then, the correction amount control section 2102 controls a correction amount at the level correction section 2103 based on the newly set reference.

Therefore, in addition to the effect by the power control apparatus 2100, the power control apparatus 2200 according to this example can adjust the reference applied to the power averaging time $T_S$ to decide the accuracy of the segment mean value of the power level according to the characteristic information on the modulation rate, etc., of an input signal as appropriate, and can thereby maintain the gain used to amplify the input signal at the gain adjusting section 2002 to an optimum state. For example, the power control apparatus 2200 decreases the power averaging time $T_S$ when the modulation rate of the input signal is high and increases the power averaging time $T_S$ when the modulation rate is low.

(Reference Example 7)

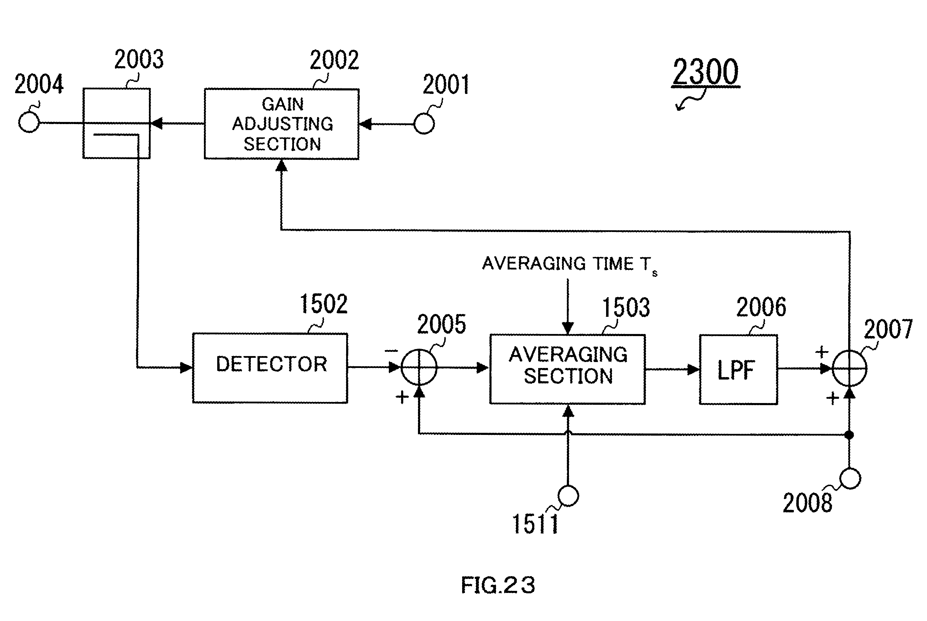

FIG.23 is a block diagram showing the configuration of a power control apparatus 2300 according to Reference Example 7. The power control apparatus 2300 is the power control apparatus 2000 according to Reference Example 4 with the subtraction section 2005 relocated between the detector 1502 and averaging section 1503. Therefore, since all the components of the power control apparatus 2300 demonstrate functions similar to those of the components of the power control apparatus 2000, explanations of the components demonstrating the similar functions will be omitted to avoid redundancy. In FIG. 23, the averaging time adjusting section 1512, power change timing analysis section 1513 and power change timing information input terminal 1514 are omitted.

The subtraction section 2005 of the power control apparatus 2300 compares the power level signal from the detector 1502 with a reference level from the reference level input terminal 2008 and the averaging section 1503 performs averaging on the difference resulting from the subtraction of the power level signal from the reference level. Therefore, the power control apparatus 2300 according to this reference example averages the difference between the reference level and the detected power level even if the total signal power level of the input signal changes during the power averaging time $T_S$, and therefore even if the total signal power level changes, it is possible to perform more accurate power control without being thereby affected.

The invention according to Reference Examples 1 to 7 can be expressed as (1) to (9) below.

(1) A first power measuring apparatus comprising a detector that generates a power level signal indicating the power level of an input signal, an averaging section that calculates a mean value of the power level signal and an adjusting section that adjusts an averaging time for which the mean value is calculated by the averaging section based on a timing at which the power level of the input signal changes.

(2) The first power measuring apparatus further comprising a selection section that selects a channel to be a reference from among a plurality of channels multiplexed on the input signal and an analyzing section that analyzes a timing at which the power level of the selected reference channel changes and delivers the analyzed timing to the adjusting section.

(3) The first power measuring apparatus further comprising a switching section that adjusts the averaging time instead of the adjusting section when the adjusting section stops operating.

(4) A first power control apparatus that amplifies an input signal with an adjustable gain and adjusts the gain through feedback based on the amplified input signal, comprising a splitter that splits the amplified input signal, a detector that generates a power level signal indicating the power level of the split input signal, an averaging section that calculates a mean value of the power level signal, an adjusting section that adjusts the averaging time for which the mean value is calculated by the averaging section based on the timing at which the power level of the input signal changes, a subtraction section that subtracts the mean value calculated by the averaging section from the reference level, an addition section that adds the difference calculated by the subtraction section to the reference level to generate a gain control value and a gain adjusting section that adjusts the gain according to the gain control value.

(5) A second power control apparatus that amplifies an input signal with an adjustable gain and adjusts the gain through feedback based on the amplified input signal, comprising a splitter that splits the amplified input signal, a detector that generates a power level signal indicating the power level of the split input signal, an averaging section that calculates a mean value of the power level signal, an adjusting section that adjusts the averaging time for which the mean value is calculated by the averaging section based on the timing at which the power level of the input signal changes, a correction section that subtracts the mean value calculated by the averaging section from the reference level, decides the accuracy of the mean value and reduces the difference obtained by subtracting the mean value from the reference level when the accuracy is decided to be insufficient, an addition section that adds the difference corrected by the correction section to the reference level to generate a gain control value and a gain adjusting section that adjusts the gain according to the gain control value.

(6) A third power control apparatus that amplifies an input signal with an adjustable gain and adjusts the gain through feedback based on the amplified input signal, comprising a splitter that splits the amplified input signal, a detector that generates a power level signal indicating the power level of the split input signal, a subtracting section that subtracts the power level signal from a reference level, an averaging section that calculates a mean value of the subtraction result by the subtraction section, an addition section that adds the mean value calculated by the averaging section to the reference level to generate a gain control value and a gain adjusting section that adjusts the gain according to the gain control value.

(7) A radio communication apparatus comprising at least any one of the first to third power control apparatuses.

(8) A first power measuring method comprising a detection step of generating a power level signal indicating the power level of an input signal, an averaging step of calculating a mean value of the power level signal and an adjusting step of adjusting an averaging time for which the mean value is calculated in the averaging step based on the timing at which the power level of the input signal changes.

(9) The first power measuring method further comprising a switching step of adjusting an averaging time for which the mean value is calculated in the averaging step instead of the adjusting step when the adjusting step is stopped.

(Reference Example 8)

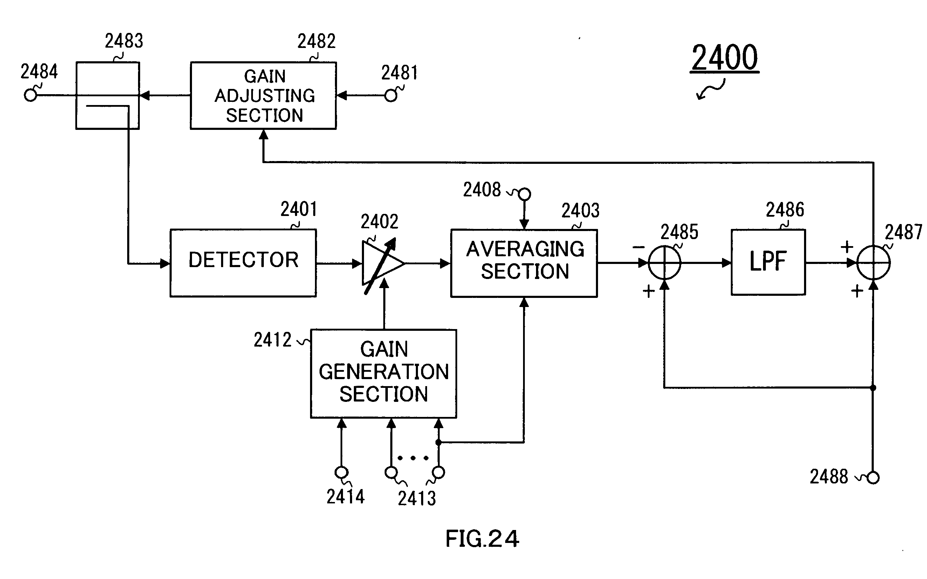

FIG.24 is a block diagram showing the configuration of a power control apparatus 2400 according to Reference Example 8. The power control apparatus 2400 is provided with a detector 2401, a level correction section 2402, an averaging section 2403, an averaging time setting input terminal 2408, a gain generation section 2412, an averaging start timing signal input terminal 2413, a power information input terminal 2414, a signal input terminal 2481, a gain adjusting section 2482, a splitter 2483, a signal output terminal 2484, a subtraction section 2485, a low pass filter (LPF) 2486, an addition section 2487 and a reference level input terminal 2488.

The detector 2401 converts the power level of a split input signal input from the splitter 2483 to a voltage and inputs the converted power level signal to the level correction section 2402.

The level correction section 2402 corrects the power level signal input from the detector 2401 using the gain (second gain) generated by the gain generation section 2412 and inputs the corrected power level signal to the averaging section 2403.

The averaging section 2403 starts to measure the power level of the power level signal corrected by the level correction section 2402 when an averaging start timing signal, for example, a slot synchronization signal is input from the averaging start timing signal input terminal 2413. Furthermore, the averaging section 2403 stores the measured value for a power averaging time $T_S$ notified through the averaging time setting input terminal 2408 and calculates a segment mean value of the power level immediately after a lapse of the power averaging time $T_S$. Then, the averaging section 2403 inputs the calculated segment mean value of the power level to the subtraction section 2485.

About an input signal input to the signal input terminal 2481, that is, an input signal obtained by code division multiplexing a plurality of channels having different timings at which their power levels change, the gain generation section 2412 generates a gain (second gain) used by the level correction section 2402 based on a channel synchronization signal of each channel input from the averaging start timing signal input terminal 2413, information on the power level of each channel input from the power information input terminal 2414 and delivers the second gain generated to the level correction section 2402. A specific gain generation procedure by the gain generation section 2412 will be explained in detail later.

The gain adjusting section 2482 adjusts a gain (first gain) according to the gain control value input from the addition section 2487 as appropriate and amplifies an input signal from the signal input terminal 2481 with the adjusted first gain. Furthermore, the gain adjusting section 2482 inputs the amplified input signal to the splitter 2483.

The splitter 2483 splits the amplified input signal input from the gain adjusting section 2482, inputs the split input signal to the detector 2401 and outputs the input signal to the signal output terminal 2484.

The subtraction section 2485 subtracts the segment mean value of the power level calculated by the averaging section 2403 from the reference level input through the reference level input terminal 2488 and inputs the difference resulting from the subtraction to the low pass filter 2486.

The low pass filter 2486 prevents the difference resulting from the subtraction input from the subtraction section 2485 to the addition section 2487 fromdrastically fluctuating.

The addition section 2487 adds the difference resulting from the subtraction at the subtraction section 2485 input through the low pass filter 2486 from the subtraction section 2485 to the reference level input through the reference level input terminal 2488 and inputs the addition value, that is, gain control value to the gain adjusting section 2482.

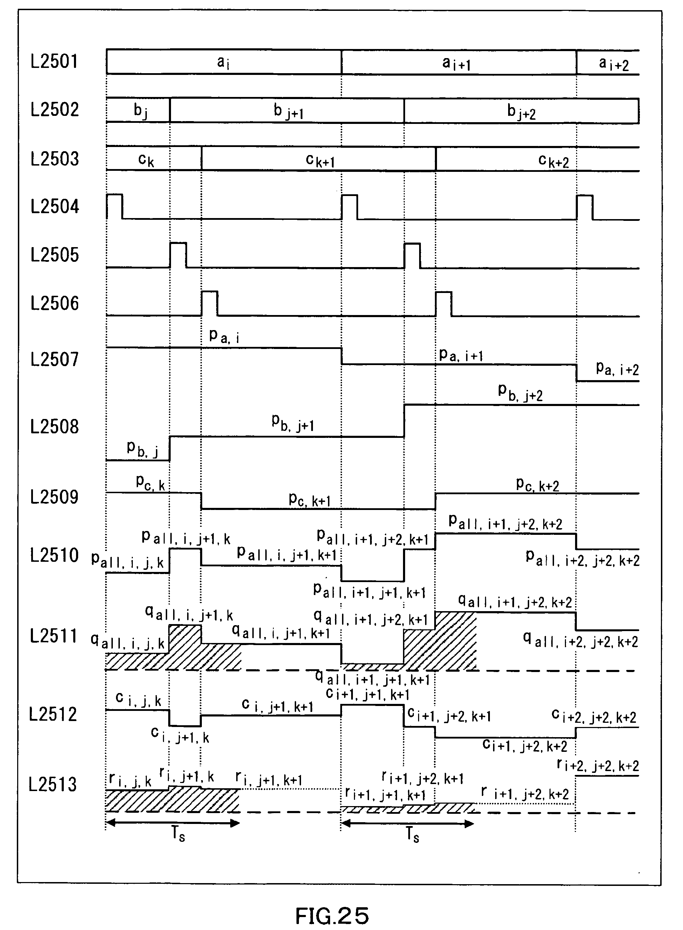

FIG.25 shows the power level, etc., of each slot of each of three channels A, B, C having different timings at which their power levels change. In FIG.25, line L2501 shows the slot configuration of channel A, line L2502 shows the slot configuration of channel B, line L2503 shows the slot configuration of channel C, line L2504 shows the slot synchronization signal of channel A, line L2505 shows the slot synchronization signal of channel B, line L2506 shows the slot synchronization signal of channel C, line L2507 shows the power level of each slot of channel A, line L2508 shows the power level of each slot of channel B, line L2509 shows the power level of each slot of channel C, line L2510 shows a desired power level of the total signal obtained by code division multiplexing channel A, channel B and channel C, line L2511 shows the power level measured about the total signal, line L2512 shows a correction amount used by the level correction section 2402, that is, a second gain, and line L2513 shows the total signal power level corrected by the level correction section 2402.

Furthermore, in FIG.25, line L2501 shows slot numbers $a_i$, $a_{i+1}$, $a_{i+2}$ of channel A, line L2502 shows slot numbers $b_j$, $b_{j+1}$, $b_{j+2}$ of channel B, line L2503 shows slot numbers $c_k$, $c_{k+1}$, $c_{k+2}$ of channel C, line L2507 shows power levels $p_{a,i}$, $p_{a,i+1}$, $p_{a,i+2}$ of channel A, line L2508 shows power levels $p_{b,j}$, $p_{b,j+1}$, $p_{b,j+2}$ of channel C, line L2509 shows power levels $p_{c,k}$, $p_{c,k+1}$, $p_{c,k+2}$ of each slot of channel C, line L2510 shows power levels $p_{all,i,j,k}$, $p_{all,i,j+1,k}$, $p_{all,i,j+1,k+1}$, $p_{all,i+1,j+1,k+1}$, $p_{all,i+1,j+2,k+1}$, $p_{all,i+1,j+2,k+2}$, $p_{all,i+2,j+2,k+2}$ through changes at a desired power level of a total signal, line L2511 shows power levels $q_{all,i,j,k}$, $q_{all,i,j+l,k}$, $q_{all,i,j+1,k+1}$, $q_{all,i+1,j+1,k+1}$, $q_{all,i+1,j+2,k+1}$, $q_{all,i+1,j+2,k+2}$, $q_{all,i+2,j+2,k+2}$ of a measured total signal, line L2512 shows second gains $c_{i,j,k}$, $c_{i,j+1,k}$, $c_{i,j+1,k+1}$, $c_{i+1,j+1,k+1}$, $c_{i+1,j+2,k+1}$, $c_{i+1,j+2,k+2}$, $c_{i+2,j+2,k+2}$ to reduce the difference in the power level before and after the power level on line L2511 changes, and line L2513 shows power levels $r_{i,j,k}$, $r_{i,j+1,k}$, $r_{i,j+1,k+1}$, $r_{i+1,j+1,k+1}$, $r_{i+1,j+2,k+1}$, $r_{i+1,j+2,k+2}$, $r_{i+2,j+2,k+2}$ on line L2511 after being corrected with a second gain of line L2512.

Next, the operation of the power control apparatus 2400 will be explained with reference to FIG.24 and FIG. 25. An input signal obtained by code division multiplexing a plurality of channels input to the signal input terminal 2481 is amplified with a first gain which is adjusted at the gain adjusting section 2482 according to a gain control value input from the addition section 2487 and then branched at the splitter 2483. Then, one portion of the input signal branched by the splitter 2483 is output to the signal output terminal 2484 and the other portion is input to the detector 2401. The input signal input to the detector 2401 is converted to a power level signal indicating the voltage and the converted power level signal is input to the level correction section 2402. The power level signal input to the level correction section 2402 is corrected with a second gain generated by the gain generation section 2412 according to the state of the input signal and then input to the averaging section 2403. The averaging section 2403 starts averaging in synchronization with, for example, a slot synchronization signal of a channel A input from the averaging start timing signal input terminal 2413, the segment mean value of the power level for the power averaging time $T_S$ input from the averaging time setting input terminal 2408 is calculated and this segment mean value is input to the subtraction section 2485. The subtraction section 2485 compares this segment mean value with the reference level input from the reference level input terminal 2488 and the difference obtained by subtracting this segment mean value from the reference level is input to the addition section 2487 through the low pass filter 2486. The addition section 2487 adds the difference through the subtraction by the subtraction section 2485 to the reference level and the addition value, that is, the gain control value is delivered to the gain adjusting section 2482. The gain adjusting section 2482 adjusts through feedback the first gain used to amplify an input signal from the signal input terminal 2481 according to the gain control value input from the addition section 2487. Thus, the first gain is adjusted through feedback by the gain adjusting section 2482 and the power level of the signal output to the signal output terminal 2484 is thereby controlled to a desired value accurately.

The gain generation section 2412 generates a second gain to be used at the level correction section 2402 based on a slot synchronization signal of each channel of an input signal input from the averaging start timing signal input terminal 2413 and information on the power level of each channel input from the power information input terminal 2414. In the procedure for generating the second gain, when, for example, averaging of the power level is started in synchronization with the slot synchronization signal of channel A shown in FIG.25, the gain generation section 2412 generates the second gain using the desired power level of the total signal on line L2510 as shown in Expression (1) below.

Expression (1)

$$c_{i,j,k} = 1 \text{ [time] (at start of averaging, desired total}$$

$$\text{signal power level} = p_{all,i,j,k})$$

$$c_{i,j+1,k} = p_{all,i,j,k} / p_{all,i,j+1,k} \text{ [times] (desired total}$$

$$\text{signal power level} = p_{all,i,j+1,k})$$

$$c_{i,j+1,k+1} = p_{all,i,j,k} / p_{all,i,j+1,k+1} \text{ [times] (desired total}$$

$$\text{signal power level} = p_{all,i,j+1,k+1})$$

That is, the gain generation section 2412 generates the second gain so that line L2513 indicating the power level of a power level signal input from the level correction section 2402 to the averaging section 2403 becomes a power measurement result ($q_{all,i,j,k}$) at the start of averaging. There is actually an error between line L2510 indicating the desired total signal power level and L2511 indicating the measured total signal power level. However, under a condition under which the error is small, the power levels $r_{i,j,k}$, $r_{i,j+1,k}$, $r_{i,j+1,k+1}$ of line L2513 become substantially equal to $q_{all,i,j,k}$ which is a power measurement result at the start of averaging as shown in Expression (2) below.

Expression (2)

$$r_{i,j,k} = q_{all,i,j,k}$$

$$r_{i,j+1,k} = q_{all,i,j+1,k} \times c_{i,j+1,k} = q_{all,i,j+1,k} \times p_{all,i,j,k} / p_{all,i,j+1,k} \doteq q_{all,i,j,k}$$

$$(\because p_{all,i,j,k} \doteq q_{all,i,j,k}, \quad p_{all,i,j+1,k} \doteq q_{all,i,j+1,k})$$

$$r_{i,j+1,k+1} = q_{all,i,j+1,k+1} \times c_{i,j+1,k+1} = q_{all,i,j+1,k+1} \times p_{all,i,j,k} / p_{all,i,j+1,k+1} \doteq q_{all,i,j,k}$$

$$(\because p_{all,i,j,k} \doteq q_{all,i,j,k}, \quad p_{all,i,j+1,k+1} \doteq q_{all,i,j+1,k+1})$$

Thus, the power level signal is corrected using the second gain every time averaging is started, and the power measurement result within the power averaging time $T_S$ is thereby resistant to influences of variations in the total transmission power level. The total signal power level used to generate the second gain is calculated based on the power information of each channel input from the power information input terminal 2414.

This reference example has explained the three channels having the same period during which the power level changes and having different timings thereof, but the invention disclosed in this reference example is likewise applicable to four or more channels having different periods during which the power level of each channel changes.

Therefore, according to the power control apparatus 2400 according to this reference example, even if the total signal power level (line L2511) changes during the power averaging time $T_s$, the level correction section 2402 corrects the power level after detection at the detector 2401 as appropriate, and therefore the amplification of an input signal by the gain adjusting section 2482 is resistant to influences of changes at the total signal power level, allowing more accurate, detailed power control.

Therefore, the radio communication apparatus provided with the power control apparatus 2400 according to this reference example can measure the power level accurately even if the power level of the input signal changes during the measurement period, and can thereby realize high communication quality.

(Reference Example 9)

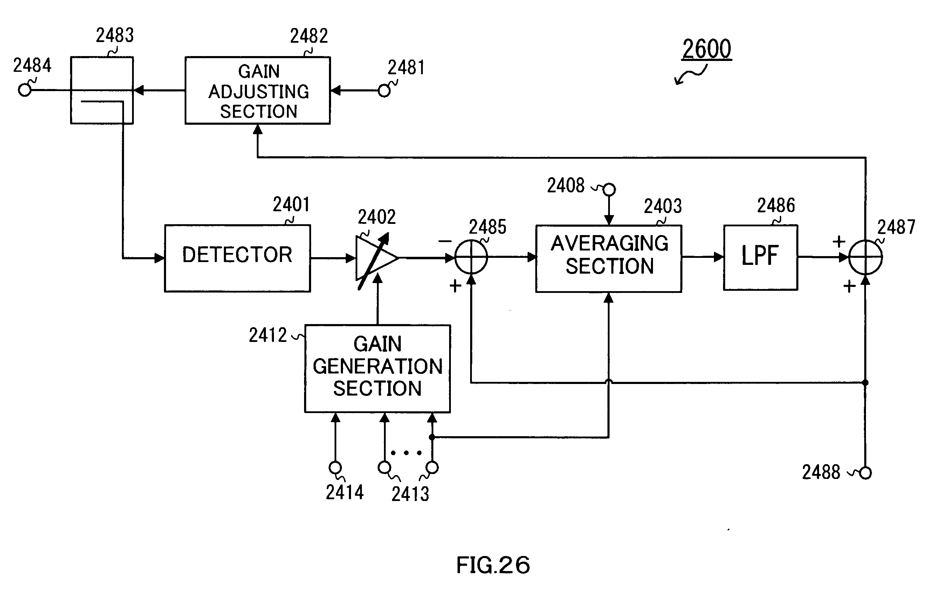

FIG.26 is a block diagram showing the configuration of a power control apparatus 2600 according to Reference Example 9. The power control apparatus 2600 is the power control apparatus 2400 according to Reference Example 8 with the subtraction section 2485 relocated between the level correction section 2402 and averaging section 2403. Therefore, since all the components of the power control apparatus 2600 demonstrate functions similar to those of the components of the power control apparatus 2400, explanations of the components demonstrating the similar functions will be omitted to avoid redundancy.

In the power control apparatus 2600, the subtraction section 2485 compares the corrected power level signal from the level correction section 2402 and the reference level from the reference level input terminal 2488 and the averaging section 2403 averages the difference obtained by subtracting the power level signal from the reference level.

Therefore, according to the power control apparatus 2600 according to this reference example, even if the total signal power level of the input signal changes within the power averaging time $T_S$, the difference between the reference level and the detected power level is averaged, and therefore even if the total signal power level changes, it is possible to perform more accurate power control without being thereby affected.

The aforementioned inventions according to Reference Example 8 and Reference Example 9 can be expressed as (10) to (13) below.

(10) A fourth power control apparatus which amplifies an input signal with a first gain and adjusts the first gain through feedback based on the amplified input signal, comprising a splitter that splits the amplified input signal, a detector that generates a power level signal indicating the power level of the split input signal, a gain generation section that calculates the ratio of power levels before and after the power level of the input signal changes based on information on the power level of the input signal and generates a second gain that approximates the calculated ratio to 1 to 1, a level correction section that corrects the power level of the power level signal with the generated second gain, an averaging section that calculates a mean value of the power level signal whose level has been corrected, a subtraction section that subtracts the mean value calculated by the averaging section from the reference level, an addition section that adds the difference calculated by the subtraction section to the reference level and generates a gain control value and a gain adjusting section that adjusts the first gain according to the gain control value generated.

(11) A fifth power control apparatus which amplifies an input signal with a first gain and adjusts the first gain through feedback based on the amplified input signal, comprising a splitter that splits the amplified input signal, a detector that generates a power level signal indicating the power level of the split input signal, a gain generation section that calculates the ratio of power levels before and after the power level of the input signal changes based on information on the power level of the input signal and generates a second gain that approximates the calculated ratio to 1 to 1, a level correction section that corrects the power level of the power level signal with the generated second gain, a subtraction section that subtracts the power level corrected by the level correction section from the reference level, an averaging section that calculates a mean value of the subtracted reference level, an addition section that adds the calculated mean value to the reference level and generates a gain control value and a gain adjusting section that adjusts the first gain according to the gain control value.

(12) A radio communication apparatus comprising the fourth or fifth power control apparatus.

(13) A power control method which amplifies an input signal with a first gain and adjusts the first gain through feedback based on the amplified input signal, comprising a splitting step of splitting the amplified input signal, a detecting step of generating a power level signal indicating the power level of the split input signal, a gain generating step of calculating the ratio of power levels before and after the power level of the input signal changes based on information on the power level of the input signal and generating a second gain that approximates the calculated ratio to 1 to 1, a level correcting step of correcting the power level of the power level signal with the generated second gain, an averaging step of calculating a mean value of the power level signal whose level has been corrected, a subtracting step of subtracting the mean value calculated in the averaging step from the reference level, an adding step of adding the difference calculated in the subtracting step to the reference level and generating a gain control value and a gain adjusting step of adjusting the first gain according to the gain control value.

It is also possible to combine the invention disclosed in Embodiment 1 to 8, the invention disclosed in Reference Example 1 to 7 and the invention disclosed in Reference Example 8, 9 as appropriate. For example, it is also possible to adapt the invention so that the averaging start timing signal generated by the averaging start timing control section 105 according to Embodiment 1 to 8 is input from the averaging start timing signal input terminal 1511 according to Reference Example 1 to 7 or the averaging start timing signal input terminal 2413 according to Reference Example 8, 9. Furthermore, it is also possible to adapt the invention so that the power averaging time $T_S$ calculated by the averaging time adjusting section 1512 according to Reference Example 1 to 7 is input from the averaging time setting input terminal 2408 according to Reference Example 7, 8.

The present application is based on Japanese Patent Application No.2003-365273, Japanese Patent Application No.2003-365274 and Japanese Patent Application No.2003-365275, filed on October 24, 2003, entire content of which is expressly incorporated by reference herein.

Industrial Applicability

The power measuring apparatus, power control apparatus, radio communication apparatus and power measuring method according to the present invention have the effect of being able to accurately measure a total signal power level of a signal obtained by multiplexing a plurality of channels having different periods and timings at which their power levels change and is suitable for use as a base station and mobile station, etc., used in a radio communication system.

[FIG.1]

12 DETECTOR
13 AVERAGING SECTION

[FIG.2]
TIME ELAPSED
[FIG.3]
TIME ELAPSED
[FIG.4]

102 DETECTOR

EP 1 659 698 A1

103 AVERAGING SECTION
106 POWER CHANGE TIMING ANALYSIS SECTION
105 AVERAGING START TIMING CONTROL SECTION

[FIG.5]
TIME ELAPSED
[FIG.6]
TIME ELAPSED
[FIG.7]
TIME ELAPSED
[FIG.8]

501 AVERAGING TIME ADJUSTING SECTION
102 DETECTOR
103 AVERAGING SECTION
106 POWER CHANGE TIMING ANALYSIS SECTION
105 AVERAGING START TIMING CONTROL SECTION

[FIG.9]

102 DETECTOR
103 AVERAGING SECTION
106 POWER CHANGE TIMING ANALYSIS SECTION
105 AVERAGING START TIMING CONTROL SECTION
601 REFERENCE CHANNEL SELECTION SECTION

[FIG.10]

102 DETECTOR
103 AVERAGING SECTION
106 POWER CHANGE TIMING ANALYSIS SECTION
105 AVERAGING START TIMING CONTROL SECTION

[FIG.11]

802 GAIN ADJUSTING SECTION
102 DETECTOR
103 AVERAGING SECTION
106 POWER CHANGE TIMING ANALYSIS SECTION
105 AVERAGING START TIMING CONTROL SECTION

[FIG.12]

802 GAIN ADJUSTING SECTION
501 AVERAGING TIME ADJUSTING SECTION
102 DETECTOR
103 AVERAGING SECTION
106 POWER CHANGE TIMING ANALYSIS SECTION
105 AVERAGING START TIMING CONTROL SECTION
802 CORRECTION AMOUNT CONTROL SECTION

[FIG.13]

802 GAIN ADJUSTING SECTION
501 AVERAGING TIME ADJUSTING SECTION
102 DETECTOR
103 AVERAGING SECTION
106 POWER CHANGE TIMING ANALYSIS SECTION

105 AVERAGING START TIMING CONTROL SECTION
902 CORRECTION AMOUNT CONTROL SECTION

[FIG.14]

802 GAIN ADJUSTING SECTION
102 DETECTOR
103 AVERAGING SECTION

[FIG.15]

1513 POWER CHANGE TIMING ANALYSIS SECTION
1512 AVERAGING TIME ADJUSTING SECTION
1502 DETECTOR
1503 AVERAGING SECTION

[FIG.16]
TIME ELAPSED
[FIG.17]
TIME ELAPSED
[FIG.18]

1811 REFERENCE CHANNEL SELECTION SECTION
106 POWER CHANGE TIMING ANALYSIS SECTION
1512 AVERAGING TIME ADJUSTING SECTION
1502 DETECTOR
1503 AVERAGING SECTION

[FIG.19]

1513 POWER CHANGE TIMING ANALYSIS SECTION
1512 AVERAGING TIME ADJUSTING SECTION
1502 DETECTOR
1503 AVERAGING SECTION

[FIG.20]

2002 GAIN ADJUSTING SECTION
1513 POWER UPDATE TIMING ANALYSIS SECTION
1512 AVERAGING TIME ADJUSTING SECTION
1502 DETECTOR
1503 AVERAGING SECTION

[FIG.21]

2002 GAIN ADJUSTING SECTION
1513 POWER CHANGE TIMING ANALYSIS SECTION
1512 AVERAGING TIME ADJUSTING SECTION
1502 DETECTOR
1503 AVERAGING SECTION
2102 CORRECTION AMOUNT CONTROL SECTION

[FIG.22]

2002 GAIN ADJUSTING SECTION
1513 POWER CHANGE TIMING ANALYSIS SECTION
1512 AVERAGING TIME ADJUSTING SECTION
1502 DETECTOR

1503 AVERAGING SECTION
2102 CORRECTION AMOUNT CONTROL SECTION

[FIG.23]

2002 GAIN ADJUSTING SECTION
AVERAGING TIME $T_s$
1502 DETECTOR
1503 AVERAGING SECTION

[FIG.24]

2482 GAIN ADJUSTING SECTION
2401 DETECTOR
2403 AVERAGING SECTION
2412 GAIN GENERATION SECTION

[FIG.26]

2482 GAIN ADJUSTING SECTION
2401 DETECTOR
2403 AVERAGING SECTION
2412 GAIN GENERATION SECTION

**Claims**

1. A power measuring apparatus comprising:

   a detector that generates a power level signal indicating a power level of an input signal;
   an averaging section that calculates a mean value of said power level signal; and
   a control section that causes said averaging section to start to calculate a mean value based on a timing at which the power level of said input signal changes.

2. The power measuring apparatus according to claim 1, further comprising an adjusting section that adjusts an averaging time for which a mean value is calculated by said averaging section based on a timing at which the power level of said input signal changes.

3. The power measuring apparatus according to claim 1, further comprising:

   a selection section that selects a channel to be a reference from among a plurality of channels multiplexed on said input signal; and
   an analyzing section that analyzes a timing at which the power level of the selected reference channel changes and delivers the analyzed timing to said control section.

4. The power measuring apparatus according to claim 1, further comprising a switching section that inputs a signal that causes said averaging section instead of said control section to start to calculate a mean value when said control section stops operating.

5. A power control apparatus that amplifies an input signal with an adjustable gain and adjusts said gain through feedback based on the amplified input signal, comprising:

   a splitter that splits the amplified input signal;
   a detector that generates a power level signal indicating the power level of the split input signal;
   an averaging section that calculates a mean value of said power level signal;
   a control section that causes said averaging section to start to calculate a mean value based on the timing at which the power level of the split input signal changes;
   a subtraction section that subtracts the mean value calculated by said averaging section from a reference level;

an addition section that adds the difference calculated by said subtraction section to said reference level to generate a gain control value; and
a gain adjusting section that adjusts said gain according to said gain control value.

6. A power control apparatus that amplifies an input signal with an adjustable gain and adjusts said gain through feedback based on the amplified input signal, comprising:

a splitter that splits the amplified input signal;
a detector that generates a power level signal indicating the power level of the split input signal;
an averaging section that calculates a mean value of said power level signal;
a control section that causes said averaging section to start to calculate a mean value based on a timing at which the power level of the split input signal changes;
a correction section that subtracts the mean value calculated by said averaging section from a reference level, decides the accuracy of said mean value and reduces, when the accuracy is decided to be insufficient, the difference obtained by subtracting said mean value from said reference level;
an addition section that adds the correction value by said correction section to said reference level to generate a gain control value; and
a gain adjusting section that adjusts said gain according to said gain control value.

7. A power control apparatus that amplifies an input signal with an adjustable gain and adjusts said gain through feedback based on the amplified input signal, comprising:

a splitter that splits the amplified input signal;
a detector that generates a power level signal indicating the power level of the split input signal;
a subtraction section that subtracts said power level signal from a reference level;
an averaging section that calculates a mean value of said subtracted reference level;
a control section that causes said averaging section to start to calculate a mean value based on a timing at which said power level of the split input signal changes;
an addition section that adds said mean value to said reference level to generate a gain control value; and
a gain adjusting section that adjusts said gain according to said gain control value.

8. A radio communication apparatus comprising the power control apparatus according to claim 5.

9. A radio communication apparatus comprising the power control apparatus according to claim 6.

10. A radio communication apparatus comprising the power control apparatus according to claim 7.

11. A power measuring method comprising:

a detection step of generating a power level signal indicating the power level of an input signal;
an averaging step of calculating a mean value of said power level signal; and
a control step of causing a calculation of a mean value to start in said averaging step based on the timing at which the power level of said input signal changes.

12. The power measuring method according to claim 9, further comprising a switching step of causing a calculation of a mean value to start in said averaging step instead of said control step when said control step is stopped.

PRIOR ART

10

16

11          12          13          14
○→  DETECTOR  →  AVERAGING
                  SECTION  →○

15

FIG.1

EP 1 659 698 A1

PRIOR ART

TIME ELAPSED

| L21 | $a_i$ | $a_{i+1}$ | $a_{i+2}$ |

$T_{slot}$

L22

L23

$T_s$   $T_s$

FIG.2

EP 1 659 698 A1

PRIOR ART

TIME ELAPSED

FIG.3

L31 $a_i$ $a_{i+1}$ $a_{i+2}$

L32 $b_j$ $b_{j+1}$ $b_{j+2}$

L33

L34

$T_{slot}$ $T_{slot}$ $T_{diff}$ $T_s$ $T_s$

FIG.4

FIG.5

EP 1 659 698 A1

FIG.6

EP 1 659 698 A1

FIG.7

FIG.8

EP 1 659 698 A1

FIG.9

EP 1 659 698 A1

EP 1 659 698 A1

700

FIG.10

FIG.11

EP 1 659 698 A1

FIG.12

EP 1 659 698 A1

FIG.13

EP 1 659 698 A1

EP 1 659 698 A1

1100

804 ○ — 803 — 802 GAIN ADJUSTING SECTION ← 801 ○

108 ○

102 DETECTOR — 805 ⊕ + — 103 AVERAGING SECTION — 806 LPF + — 807 ⊕ +

1102 ○

808 ○

FIG.14

EP 1 659 698 A1

$\underline{1500}$

```
         1514 ──○──▶ ┌──────────────────┐  ──▶ ┌──────────────────┐
                ○──▶ │  POWER CHANGE    │      │  AVERAGING TIME  │
                ○──▶ │ TIMING ANALYSIS  │      │ ADJUSTING SECTION│
                     │     SECTION      │      │                  │
                     └──────────────────┘      └──────────────────┘
```

1513    POWER CHANGE TIMING ANALYSIS SECTION

1512    AVERAGING TIME ADJUSTING SECTION

1501    DETECTOR    1502

1503    AVERAGING SECTION    1504

1511

FIG.15

FIG.16

EP 1 659 698 A1

EP 1 659 698 A1

TIME ELAPSED

L1701

$q_{1, i}$     $q_{1, i+1}$     $q_{1, i+2}$     $q_{1, i+3}$

L1702

$q_{2, j}$     $q_{2, j+1}$

L1703

$q_{3, k}$     $q_{3, k+1}$     $q_{3, k+2}$

L1704

$q_{4, m}$     $q_{4, m+1}$     $q_{4, m+2}$

L1705

$q_{5, n}$     $q_{5, n+1}$

$T_{s, i}$     $T_{s, i+1}$     $T_{s, i+2}$

FIG.17

FIG.18

EP 1 659 698 A1

FIG.19

**2000**

2004  2003  2002  2001

GAIN
ADJUSTING
SECTION

1500

POWER UPDATE
TIMING ANALYSIS
SECTION

AVERAGING TIME
ADJUSTING
SECTION

1514

1513  1512  1503

DETECTOR  1502

AVERAGING
SECTION

2005  2006  2007

LPF

1511

2008

**FIG.20**

FIG.21

FIG.22

FIG.23

EP 1 659 698 A1

FIG.24

FIG.25

2600

2487

2486 LPF

2488

2403 AVERAGING SECTION

2408

2485

2402

GAIN GENERATION SECTION 2412

2413

2414

2481

2482 GAIN ADJUSTING SECTION

2483

2484

2401 DETECTOR

FIG.26

## INTERNATIONAL SEARCH REPORT

| International application No. |
| --- |
| PCT/JP2004/015726 |

**A. CLASSIFICATION OF SUBJECT MATTER**
Int.Cl⁷ H04B1/04

According to International Patent Classification (IPC) or to both national classification and IPC

**B. FIELDS SEARCHED**

Minimum documentation searched (classification system followed by classification symbols)
Int.Cl⁷ H04B1/04

Documentation searched other than minimum documentation to the extent that such documents are included in the fields searched

| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2001-326700 A (Hitachi Kokusai Electric Inc.), 22 November, 2001 (22.11.01), Par. Nos. [0018] to [0028]; Figs. 1, 4 (Family: none) | 1,11 |
| A | JP 2001-86010 A (NEC Corp.), 30 March, 2001 (30.03.01), Par. Nos. [0026] to [0058]; Figs. 1, 3 & CN 1288302 A & GB 2356749 A & US 6591089 B1 | 1-12 |

☒ Further documents are listed in the continuation of Box C.  ☐ See patent family annex.

| * | Special categories of cited documents: |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 19 January, 2005 (19.01.05) | 01 February, 2005 (01.02.05) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

## INTERNATIONAL SEARCH REPORT

International application No.

PCT/JP2004/015726

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-10313 A (NEC Corp.), 11 January, 2002 (11.01.02), Par. Nos. [0015] to [0027]; Figs. 1, 2 & WO 2001/099462 A1    & EP 1304898 A1 & US 2004/0110524 A1 | 2 |
| A | JP 2000-201089 A (Matsushita Electric Industrial Co., Ltd.), 18 July, 2000 (18.07.00), & GB 2346492 A        & CN 1274204 A & US 6463264 B1 | 1-12 |

Form PCT/ISA/210 (continuation of second sheet) (January 2004)